(19) Europäisches Patentamt
European Patent Office
Office européen des brevets

(11) EP 4 113 351 A1

(12) # EUROPEAN PATENT APPLICATION

published in accordance with Art. 153(4) EPC

(43) Date of publication:
**04.01.2023 Bulletin 2023/01**

(21) Application number: **21759893.7**

(22) Date of filing: **17.02.2021**

(51) International Patent Classification (IPC):
***G06F 30/27*** *(2020.01)* ***C08L 23/00*** *(2006.01)*
***C08L 81/02*** *(2006.01)*

(52) Cooperative Patent Classification (CPC):
**C08L 23/00; C08L 81/02; G06F 30/27**

(86) International application number:
**PCT/JP2021/005897**

(87) International publication number:
**WO 2021/172127 (02.09.2021 Gazette 2021/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.02.2020 US 202062982756 P**
**23.09.2020 JP 2020159132**

(71) Applicants:
- **DIC Corporation**
  **Tokyo 174-8520 (JP)**
- **National Institute Of Advanced Industrial Science and Technology**
  **Chiyoda-ku**
  **Tokyo 100-8921 (JP)**

(72) Inventors:
- **TAKADA Shingo**
  **Sakura-shi, Chiba 285-8668 (JP)**
- **SUZUKI Toru**
  **Ichihara-shi, Chiba 290-8585 (JP)**
- **YAMAJI Toshinori**
  **Sakura-shi, Chiba 285-8668 (JP)**
- **TAKEBAYASHI Yoshihiro**
  **Tsukuba-shi, Ibaraki 305-8560 (JP)**
- **ONO Takumi**
  **Tsukuba-shi, Ibaraki 305-8560 (JP)**
- **YODA Satoshi**
  **Tsukuba-shi, Ibaraki 305-8560 (JP)**

(74) Representative: **Beckmann, Claus**
**Kraus & Weisert**
**Patentanwälte PartGmbB**
**Thomas-Wimmer-Ring 15**
**80539 München (DE)**

(54) **METHOD FOR DETERMINING MANUFACTURING CONDITION FOR POLYARYLENE SULFIDE RESIN COMPOSITION, AND METHOD FOR MANUFACTURING RESIN COMPOSITION**

(57) A method for optimizing manufacturing conditions for a polyarylene sulfide resin composite includes executing a machine learning algorithm using a data set including manufacturing conditions data and measured characteristics data. The manufacturing conditions data includes the manufacturing conditions items of at least ingredients for the polyarylene sulfide resin composite, mixing conditions, and polymer melt temperature during melt kneading, whereas the measured characteristics data includes the characteristic value item of at least the impact resistance of the polyarylene sulfide resin composite when produced under the manufacturing conditions specified by the manufacturing conditions data. Through the execution of the algorithm, it is found out which of the multiple items included in the manufacturing conditions data and the measured characteristics data is highly important for changes in a characteristic value for a target item for improved characteristics of the polyarylene sulfide resin composite selected as the objective variable.

FIG. 2

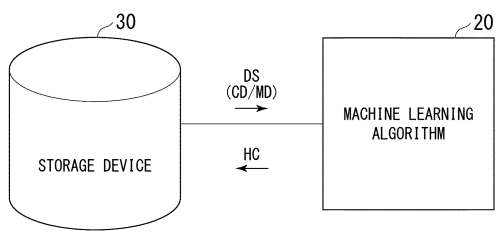


EP 4 113 351 A1

## Description

### Technical Field

The present invention relates to a method for optimizing manufacturing conditions for a polyarylene sulfide resin composite and a method for manufacturing a resin composite.

The present application claims priority based on U.S. Provisional Application No. US 62/982,756, filed in the United States on February 28, 2020, and Japanese Patent Application No. 2020-159132, filed in Japan on September 23, 2020, the contents of which are incorporated by reference herein.

### Background Art

Polyarylene sulfide resins, typified by polyphenylene sulfide resins, are superior in heat resistance, chemical resistance, etc., and enjoy a wide variety of applications including electric and electronic components, automotive components, mechanical components, boiler components, fibers, and films.

A known technology for producing a polyarylene sulfide resin composite is to use a melt kneading process. In such a technology, the manufacturer performs polymer blending by mixing pellets of two or more resins together, heating the mixed pellets while stirring them by rotation with a screw, and extruding the kneaded resins (e.g., see PTL 1).

In automotive and other vehicle components applications in particular, there is a demand for resin materials superior in impact resistance and other mechanical properties as an alternative to metals for weight reduction purposes. As a way to improve the impact resistance of a polyarylene sulfide resin, it may be explored in some cases how to add an elastomer component. PTL 2 discloses a method for producing a polyarylene sulfide resin composite in which a polyarylene sulfide resin (A) and thermoplastic elastomer particles having a volume average diameter of 0.1 mm to 3.0 mm (B) are melted and kneaded together in such proportions that the thermoplastic elastomer particles (B) will constitute 0.1% by mass to 2.0% by mass of all ingredients.

### Citation List

### Patent Literature

PTL 1: Japanese Unexamined Patent Application Publication No. 2017-149002
PTL 2: Japanese Unexamined Patent Application Publication No. 2008-163112

### Summary of Invention

### Technical Problem

Such a melt kneading process involves a myriad of parameters to control as manufacturing conditions, and the individual parameters interact in a complicated manner. The process of determining the right parameter values to give for boosting the impact resistance of the polyarylene sulfide resin composite has relied on skilled engineers' experience and intuition.

An object of the present invention, therefore, is to provide a method for optimizing manufacturing conditions for a polyarylene sulfide resin composite whereby the manufacturer can optimize the control parameters without relying on engineers' experience and intuition.

If an elastomer component is added to a polyarylene sulfide resin composite, the impact resistance is expected to improve with higher percentages of the elastomer component and higher dispersibility of the elastomer component.

If one tries to add a higher percentage of the elastomer component than specified above in making the polyarylene sulfide resin composite of PTL 2, however, there remains room for improvement when it comes to dispersing the elastomer component better in the resin composite.

An object of the present invention, therefore, is to provide a method for manufacturing a polyarylene sulfide resin composite that exhibits excellent impact resistance. Solution to Problem

After extensive research to solve the above problems, the inventors found a machine learning algorithm-based analysis performed using a data set based on acquired data, described below, provides a way to determine the right control parameters. The present invention was completed on the basis of these findings.

After extensive research to solve the above problems, furthermore, the inventors found when the kneading is performed at a shear rate equal to or higher than a particular limit and under particular preset temperature conditions

with an increased amount of the elastomer component, the resulting polyarylene sulfide resin composite exhibits excellent impact resistance. The present invention was completed on the basis of these findings.

That is, the present invention has the following aspects.

A method according to an aspect of the present invention for optimizing manufacturing conditions for a polyarylene sulfide resin composite includes executing a machine learning algorithm using a data set including manufacturing conditions data and measured characteristics data, the manufacturing conditions data including manufacturing conditions items of at least ingredients for the polyarylene sulfide resin composite, mixing conditions, and polymer melt temperature during melt kneading whereas the measured characteristics data including a characteristic value item of at least impact resistance of the polyarylene sulfide resin composite when produced under manufacturing conditions specified by the manufacturing conditions data, to find out which of the multiple items in the manufacturing conditions data and the measured characteristics data is highly important for changes in a characteristic value for a target item for improved characteristics of the polyarylene sulfide resin composite selected as an objective variable.

In a method according to an aspect of the present invention for optimizing manufacturing conditions for a polyarylene sulfide resin composite, furthermore, the machine learning algorithm is a random forest-based algorithm, and the item highly important for changes in the characteristic value for the target item for improved characteristics is found out by calculating importance of each of the multiple items in the manufacturing conditions data and the measured characteristics data.

In a method according to an aspect of the present invention for optimizing manufacturing conditions for a polyarylene sulfide resin composite, furthermore, the manufacturing conditions items in the manufacturing conditions data include at least one in a first class, which is to be controlled by a production system with which the polyarylene sulfide resin composite is manufactured, and at least one in a second class, which is not to be controlled by the production system.

In a method according to an aspect of the present invention for optimizing manufacturing conditions for a polyarylene sulfide resin composite, furthermore, the manufacturing condition item in the second class includes internal temperatures of a kneader of the production system, at which a polyarylene sulfide resin is kneaded, at multiple points.

In a method according to an aspect of the present invention for optimizing manufacturing conditions for a polyarylene sulfide resin composite, furthermore, an upstream one, which is on a side where raw materials for the polyarylene sulfide resin composite are introduced into the kneader, of the internal temperatures of the kneader at multiple points, which are manufacturing conditions items in the second class, has a higher level of the importance than a downstream one, which is on a side where the kneaded polyarylene sulfide resin composite is extruded.

In a method according to an aspect of the present invention for optimizing manufacturing conditions for a polyarylene sulfide resin composite, furthermore, the machine learning algorithm is executed with the item with high calculated importance as a new objective variable to find out which item is highly important for changes in a characteristic value for the new objective variable.

In a method according to an aspect of the present invention for optimizing manufacturing conditions for a polyarylene sulfide resin composite, furthermore, a regression operation using the data set is performed with the item with a high calculated level of the importance as an analytical axis to estimate correspondence between changes in a characteristic value for the item with a high level of the importance and changes in the characteristic value for the objective variable.

A method according to an aspect of the present invention for manufacturing a polyarylene sulfide resin composite is a method for manufacturing a polyarylene sulfide resin composite containing a polyarylene sulfide resin (A) and a thermoplastic elastomer (B),
a percentage of the thermoplastic elastomer (B) being between 5% and 30% by mass of a total mass of the polyarylene sulfide resin composite, the method including:
a step of melting and kneading a raw-material polyarylene sulfide resin (A) and a raw-material thermoplastic elastomer (B) with an extruder, wherein:

> a shear rate the extruder generates by rotating a screw thereof with respect to an inner wall of a cylinder thereof is between 1000 and 6500 $s^{-1}$; and
>
> a preset temperature of the cylinder is below 300°C over a length of the cylinder equal to or longer than 3/15 of a whole length of the cylinder.

In a method according to an aspect of the present invention for manufacturing a polyarylene sulfide resin composite, the thermoplastic elastomer (B) is a polyolefin thermoplastic elastomer.

In a method according to an aspect of the present invention for manufacturing a polyarylene sulfide resin composite, the thermoplastic elastomer (B) is a glycidyl-modified polyolefin thermoplastic elastomer.

In a method according to an aspect of the present invention for manufacturing a polyarylene sulfide resin composite, the thermoplastic elastomer (B) contains:

0.1% to 30% by mass of a glycidyl (meth)acrylate-derived unit; and
0.1% to 50% by mass of a methyl acrylate-derived unit,
both based on a total mass (100% by mass) of units forming the thermoplastic elastomer (B).

In a method according to an aspect of the present invention for manufacturing a polyarylene sulfide resin composite, the resin composite has a dispersion structure in which an average diameter of dispersed particles of the thermoplastic elastomer (B) is 0.20 μm or less.

In a method according to an aspect of the present invention for manufacturing a polyarylene sulfide resin composite, a Charpy notched impact value at 23°C of an article shaped from the resin composite measured as per ISO 179-1 is 40 $kJ/m^2$ or more.

Advantageous Effects of Invention

According to the present invention, there is provided a method for optimizing manufacturing conditions for a polyarylene sulfide resin composite whereby the manufacturer can optimize the control parameters without relying on engineers' experience and intuition.

According to the present invention, there is provided a method for manufacturing a polyarylene sulfide resin composite that exhibits excellent impact resistance.

Brief Description of Drawings

[Fig. 1] Fig. 1 is a diagram for describing the functional configuration of a twin-screw extruder according to this embodiment.
[Fig. 2] Fig. 2 is a diagram for describing a machine learning algorithm according to this embodiment.
[Fig. 3] Fig. 3 is a diagram for describing a data set according to this embodiment.
[Fig. 4] Fig. 4 is a diagram for describing an example of importance calculated by a machine learning algorithm according to this embodiment.
[Fig. 5] Fig. 5 is a diagram for describing the results of an operation done by a machine learning algorithm according to this embodiment with the elastomer ratio and IR1 temperature as highly critical items and the Charpy impact value as the objective variable.
[Fig. 6] Fig. 6 is a flowchart for describing the workflow of a method according to this embodiment for optimizing manufacturing conditions for a polyarylene sulfide resin composite.
[Fig. 7] Fig. 7 is a schematic diagram illustrating an example of a structure of a resin composite according to an embodiment.
[Fig. 8] Fig. 8 is a schematic diagram illustrating the structure of an extruder used in Examples.
[Fig. 9] Fig. 9 is an image illustrating the shape of a test specimen used in the measurement of the Charpy impact value.

Description of Embodiments

[Outline of a Twin-Screw Extruder]

The following describes a method according to an embodiment of the present invention for optimizing manufacturing conditions for a polyarylene sulfide resin composite with reference to drawings.

Fig. 1 is a diagram for describing the functional configuration of a twin-screw extruder 10 according to this embodiment. With reference to this drawing, the following describes the functional configuration of a twin-screw extruder 10 according to this embodiment. The twin-screw extruder 10 includes a driver 11, at least one feeder 12, a cylinder 13, screws 14, and at least one infrared temperature sensor IR.

The feeder 12 is an inlet for introducing the raw materials for the polyarylene sulfide resin composite according to an embodiment through.

In this embodiment, polyarylene sulfide resin composites include a broad range of resin composites containing a polyarylene sulfide. The raw materials for the polyarylene sulfide resin composite can include a polyarylene sulfide. An example of a polyarylene sulfide is polyphenylene sulfide. It should be noted that the raw materials for the polyarylene sulfide resin composite include ingredients for the polyarylene sulfide resin composite and precursors to the ingredients.

The raw materials for the polyarylene sulfide resin composite may further include any ingredient that will be mixed with the polyarylene sulfide. If the polyarylene sulfide is mixed with an elastomer, the elastomer is also introduced through the feeder 12. The number of feeders 12 may be one, or there may be two or more so that the raw materials

for the polyarylene sulfide resin composite can be introduced separately.

The cylinder 13 has a cylindrical shape. One end of the cylinder 13 is coupled to the feeder 12, and the other end is coupled to the die 19. In the following description, the feeder 12 side of the cylinder 13 may be described as the upstream side, and the die 19 side may be described as the downstream side. The cylinder 13 holds the screws 14 inside. The raw materials guided by the feeder 12 are heated by at least one heater, not illustrated. At least a subset of the raw materials (e.g., the polyarylene sulfide) melts inside the cylinder 13, while the entire introduced feedstock is kneaded by the screws 14. In the following description, the cylinder 13 is also described as the kneader. At the kneader, the raw materials for the polyarylene sulfide resin composite are kneaded. The contents of the cylinder during the melt kneading is hereinafter referred to as the polymer melt.

In this embodiment, the heater, not illustrated, may be multiple ones placed at different points in the direction of the x-axis. The multiple heaters placed at different points in the direction of the x-axis heat the cylinder 13 with different temperatures. By having multiple heaters and heating the cylinder 13 therewith with different temperatures, the twin-screw extruder 10 heats the polymer melt at different temperatures on the upstream and downstream sides of the cylinder 13. An example of a heater is a barrel that surrounds the cylinder 13.

The infrared temperature sensor IR measures the temperature of the cylinder 13. Specifically, the infrared temperature sensor IR measures the polymer melt temperature of the molding material inside the cylinder 13 during the melt kneading. The twin-screw extruder 10 may have multiple infrared temperature sensors IR. In this embodiment, the twin-screw extruder 10 has the infrared temperature sensors IR of a first infrared temperature sensor IR1, a second infrared temperature sensor IR2, a third infrared temperature sensor IR3, and a fourth infrared temperature sensor IR4, in order from the upstream end of the cylinder 13.

The screws 14 are driven to rotate by the driver 11. By being driven to rotate, the screws 14 guide the polymer melt inside the cylinder from the upstream side to the downstream side. The raw materials introduced into the feeder 12 are melted and kneaded through the cylinder 13 and extruded from the die 19 as the finished polyarylene sulfide resin composite.

The driver 11 includes components such as a motor and a gearbox, not illustrated. The driver 11 rotates the screws 14 to a predetermined screw speed (rpm) by controlling the rotational frequency, torque, etc., of the motor.

Fig. 2 is a diagram for describing a machine learning algorithm 20 according to this embodiment. With reference to this drawing, the following describes the machine learning algorithm 20.

Into the machine learning algorithm 20, a data set DS is input from a storage device 30. The machine learning algorithm 20 deduces highly critical items HC based on the input data set DS. The deduced highly critical items HC are stored in the storage device 30.

Specifically, the method in this embodiment for optimizing manufacturing conditions for a polyarylene sulfide resin composite includes executing a machine learning algorithm using a data set DS to determine highly critical items HC, items highly important for improvements in characteristics.

More specifically, the method in this embodiment for optimizing manufacturing conditions for a polyarylene sulfide resin composite includes executing a machine learning algorithm using a data set DS to find out which of multiple items included in manufacturing conditions data CD and measured characteristics data MD is highly important for changes in a characteristic value for a target item for improved characteristics of the polyarylene sulfide resin composite selected as the objective variable.

The storage device 30 stores the data set DS and the highly critical items HC therein. The following describes the data set DS with reference to a diagram.

Fig. 3 is a diagram for describing a data set DS according to this embodiment.

The data set DS includes manufacturing conditions data CD and measured characteristics data MD.

The manufacturing conditions data CD includes the manufacturing conditions items of at least the ingredients for the polyarylene sulfide resin composite, mixing conditions, and polymer melt temperature during the melt kneading.

In this embodiment, the manufacturing conditions data CD includes manufacturing conditions items in a first class, which are to be controlled by the production system with which the polyarylene sulfide resin composite is manufactured (Hereinafter also referred to as control variables or first manufacturing conditions data CD1.), and manufacturing conditions items in a second class, which are not to be controlled by the production system (Hereinafter also referred to as measured variables or second manufacturing conditions data CD2.). The second manufacturing conditions data CD2 is a collection of measured values obtained through actual measurement, i.e., values obtained uncontrolled.

Specifically, the first manufacturing conditions data CD1 includes a first modification of the elastomer, a second modification of the elastomer, the total modification, the elastomer ratio, and the screw speed. The second manufacturing conditions data CD2 includes electrical current, polymer melt pressure, IR1 temperature, IR2 temperature, IR3 temperature, and IR4 temperature. That is, the manufacturing conditions items in the second class (second manufacturing conditions data CD2) include temperatures of the kneader, at which the polyarylene sulfide is kneaded, at multiple points. The temperatures of the kneader at multiple points include internal temperatures of the kneader, specifically polymer melt temperatures or resin temperatures.

The mixing conditions include the first modification of the elastomer used, the second modification of the elastomer used, the total modification, including the first and second modifications, of the elastomer used, the elastomer ratio, and the screw speed.

The elastomer ratio can be the percentage (% by mass) of the elastomer to the total mass of the polyarylene sulfide resin composite.

The modifications of the elastomer correspond to, for example, the quantities of functional groups the thermoplastic elastomer (B) described below may have.

The electric current indicates that required to drive the screws 14 to rotate when extruding the polymer melt from the cylinder 13. As a variation, extrusion torque may be set as a measured variable instead of electric current.

The polymer melt pressure is a value measured by a pressure sensor, not illustrated, installed in the die section, which is on the downstream side of the cylinder 13.

In this embodiment, any item in the second manufacturing conditions data CD2, which is a collection of measured variables, found to be important may be incorporated in the first manufacturing conditions data CD1, which is a collection of control variables, or any item in the first manufacturing conditions data CD1, which is a collection of control variables, not found to be unimportant may be incorporated in the second manufacturing conditions data CD2, which is a collection of measured variables.

The measured characteristics data MD indicates items about characteristic values of the polyarylene sulfide resin composite when produced under the manufacturing conditions specified by the manufacturing conditions data CD. That is, the storage device 30 matches the manufacturing conditions data CD with measured characteristics data MD corresponding to the manufacturing conditions data CD and stores them as a data set DS. In the following description, the measured characteristics data MD is also described as characteristics variables.

Specifically, the measured characteristics data MD includes the characteristic value item of at least the impact resistance of the polyarylene sulfide resin composite when produced under the manufacturing conditions specified by the manufacturing conditions data CD. More specifically, the measured characteristics data MD includes melt viscosity, the average diameter of dispersed elastomer particles, and the Charpy impact value.

The melt viscosity is measured by putting a load on the resulting polyarylene sulfide resin composite. For example, the melt viscosity may be measured by introducing pellets of the polyarylene sulfide resin composite into a flow tester with an orifice length of 10 mm and an orifice diameter of 1 mm at a cylinder temperature of 300°C and putting a load of 50 kg after 6 minutes of preheating.

The average diameter of dispersed elastomer particles is a value measured on the resulting polyarylene sulfide resin composite. Specifically, the average diameter of dispersed elastomer particles may be obtained by putting the resulting polyarylene sulfide resin composite into an injection molding machine as a molding material and shaping it into a multipurpose test specimen, cutting the shaped multipurpose test specimen at the middle in the longitudinal direction and polishing the cross-section, immersing the cut piece in xylene and sonicating it at a temperature of 50°C, removing the dispersed elastomer on the cross-section by extraction with xylene, then drying the specimen at 130°C for 2 hours, observing the cross-section by SEM, and measuring the image. The image has void phases corresponding to the areas in which the elastomer has been removed, displayed in round shapes in low-brightness black. All such black round objects seen in the image's field of view may be measured on image analysis software for their equivalent circular diameter (calculated diameter of a perfect circle equivalent to the area of the round object), and the average, given by dividing the total by the number of round objects, may be reported as the average diameter of dispersed particles of the elastomer.

The Charpy impact value is a value measured on the resulting polyarylene sulfide resin composite. For example, the Charpy impact value may be measured by putting the resulting polyarylene sulfide resin composite into an injection molding machine as a molding material and shaping it into a test specimen measuring 80 mm in length × 10.0 mm in width × 4.0 mm in thickness at a preset cylinder temperature of 300°C and a preset mold temperature of 130°C, notching the test specimen according to ISO 2818, and testing it at 23°C according to ISO 179-1.

Besides these items, the measured characteristics data MD may include values that can be targets for improved characteristics, such as heat resistance at high temperatures and elastic modulus at high temperatures.

The example illustrated in Fig. 3 presents the data sets DS of data set DS1 and data set DS2. In data set DS1, the first modification of the elastomer is "3," the second modification of the elastomer is "27," the total modification is "30," the elastomer ratio is "2," the screw speed is "150," electric current is "75," resin pressure is "1.5," IR1 temperature is "306," IR2 temperature is "310," IR3 temperature is "307," IR4 temperature is "308," melt viscosity is "156," gas production is "0.14," the average diameter of dispersed elastomer particles is "0.178," and the Charpy impact value is "3.5."

In data set DS2, the first modification of the elastomer is "3," the second modification of the elastomer is "27," the total modification is "30," the elastomer ratio is "2," the screw speed is "300," electric current is "88," resin pressure is "1.4," IR1 temperature is "316," IR2 temperature is "319," IR3 temperature is "316," IR4 temperature is "316," melt viscosity is "136," gas production is "0.14," the average diameter of dispersed elastomer particles is "0.118," and the Charpy impact value is "3.6."

That is, the example illustrated in this diagram demonstrates a change in measured and characteristics variables that occurs when the screw speed as a control variable is changed from "150" to "300." Specifically, the reader can see that the Charpy impact value improved from "3.5" to "3.6" as a result of a change in screw speed from "150" to "300."

The measured and characteristics variables may be averages based on the results of repeated measurements.

Referring back to Fig. 2, the machine learning algorithm 20 calculates the importance (%) of each of the items in the data set DS it acquires. Specifically, the machine learning algorithm 20 calculates the importance using the random forest process. An example is when the machine learning algorithm 20 sets the Charpy impact value (Charpy impact strength) as the objective variable and the items other than the Charpy impact value as explanatory variables and calculates the importance of each item for the Charpy impact value. In the following description, an objective variable set as a target for improvements in characteristics is also referred to as a target item for improved characteristics.

The machine learning algorithm 20 analyzes all of the control, measured, and characteristics variables in the data set DS it acquires and calculates their importance (%).

Optionally, the settings of the hyperparameters used to calculate the importance may be changed so that the coefficient of determination (score) will be maximized. It is also allowed to use hyperparameters optimized using the grid search or Bayesian optimization process.

Fig. 4 is a diagram for describing an example of importance calculated by a machine learning algorithm 20 according to this embodiment. With reference to this diagram, the following describes an example of importance calculated by the machine learning algorithm 20.

By the machine learning algorithm 20, importance is calculated for items corresponding to the data set DS. Since the example illustrated in the diagram is that of calculated importance of each item to the Charpy impact value, the Charpy impact value is labeled as "target." Specifically, the importance of each item to the Charpy impact value is as follows: The importance of the first modification of the elastomer is "1.4," the importance of the second modification of the elastomer is "1.2," the importance of the total modification is "1.1," the importance of the elastomer ratio is "57.6," the importance of the screw speed is "3.2," the importance of electric current is "0.8," the importance of polymer melt pressure is "5.3," the importance of IR1 temperature is "11.3," the importance of IR2 temperature is "10.2," the importance of IR3 temperature is "1.1," the importance of IR4 temperature is "1.3," the importance of melt viscosity is "4.7," the importance of gas production is "0.1," and the importance of the average diameter of dispersed elastomer particles is "0.9." It should be noted that these importance values are 100 times calculated values so that the sum is 100.

Then the machine learning algorithm 20 determines highly critical items HC by a predetermined method. In other words, by calculating the importance of each of multiple items in the manufacturing conditions data CD and the measured characteristics data MD, the machine learning algorithm 20 finds out items highly important for changes in a characteristic value for a target item for improved characteristics (the Charpy impact value in this example) (i.e., highly critical items HC).

The highly critical items HC in the example illustrated in Fig. 4 are the elastomer ratio, IR1 temperature, and IR2 temperature.

In this embodiment, IR1 and IR2 temperatures are highly important among IR1 to IR4 temperatures, which are measured variables. In other words, upstream ones, which are on the side where the raw materials for the polyarylene sulfide resin composite are introduced into the kneader, of the polymer melt temperatures at multiple points of the kneader as manufacturing conditions items in the second class (measured variables) have higher importance than downstream ones, which are on the side where the kneaded polyarylene sulfide resin composite is extruded.

Regarding the predetermined method for determining highly critical items HC, the algorithm may be configured to, for example, set the top three of the calculated importance values as the highly critical items HC.

As a possible variation, the machine learning algorithm 20 may be configured to define the highly critical items HC based on a predetermined threshold. For example, if the predetermined threshold is 10, the elastomer ratio, IR1 temperature, and IR2 temperature are highly critical items HC in the example illustrated in Fig. 4.

Then, with any of the items with high calculated importance as a new objective variable, the machine learning algorithm 20 finds out which item is highly important for changes in a characteristic value for the new objective variable. Specifically, in the example illustrated in Fig. 4, the elastomer ratio, IR1 temperature, and IR2 temperature are highly critical items HC. With IR1 temperature, which is one of the highly critical items HC, as the objective variable and the items other than IR1 temperature as explanatory variables, the algorithm calculates the importance of each item to IR1 temperature using the random forest algorithm.

Overall, with a predetermined item in the data set DS as the objective variable and the items other than this one set as the objective variable as explanatory variables, the machine learning algorithm 20 calculates the importance of each item to the item set as the objective variable using the random forest algorithm. Then, with a particular one of the deduced highly critical items HC as the objective variable, the machine learning algorithm 20 makes further calculations of importance using the random forest algorithm, finding out items with high importance.

Then the machine learning algorithm 20 performs a support vector regression with items determined to be highly critical items HC. Specifically, with items with high calculated importance (highly critical items HC) as analytical

axes, the machine learning algorithm 20 performs a regression operation using the data set DS to estimate correspondence between changes in a characteristic value for the items with high importance (highly critical items HC) and changes in the characteristic value for the objective variable. The items determined to be highly critical items HC in this context may be determined by choosing from the comprehensive range of them including those determined in the first operation and those determined in the second and subsequent operations. Optionally, the settings of the hyperparameters used to perform the support vector regression may be changed so that the coefficient of determination (score) will be maximized. It is also allowed to use hyperparameters optimized using the grid search or Bayesian optimization process.

In this embodiment, the operation is performed using the support vector regression algorithm with the elastomer ratio and IR1 temperature as the highly critical items HC and the Charpy impact value as the objective variable.

Fig. 5 is a diagram for describing the results of an operation done by a machine learning algorithm according to this embodiment using the support vector regression algorithm with the elastomer ratio and IR1 temperature as the highly critical items HC and the Charpy impact value as the objective variable. In this diagram, IR1 temperature, the elastomer ratio, and the Charpy impact value are expressed as a three-dimensional graph.

The reader can see that in the example illustrated in Fig. 5, the manufacturing conditions under which the Charpy impact value improves are those including a higher elastomer ratio and an IR1 polymer melt temperature lower than 320°C.

Fig. 6 is a flowchart for describing the workflow of the method according to this embodiment for optimizing manufacturing conditions for a polyarylene sulfide resin composite. With reference to this diagram, the following describes the workflow of the method according to this embodiment for optimizing manufacturing conditions for a polyarylene sulfide resin composite.

(Step S110) The machine learning algorithm 20 acquires a data set DS from a storage device 30 by a predetermined communication technology.

(Step S120) Based on the data set DS acquired, the machine learning algorithm 20 calculates importance using random forests. In this step, the machine learning algorithm 20 calculates the importance of every one of the control, measured, and characteristics variables included in the data set DS.

(Step S130) From the multiple calculated importance values, the machine learning algorithm 20 chooses highly critical items HC, which are items with high importance, according to predetermined criteria.

(Step S140) The machine learning algorithm 20 makes a decision, according to predetermined criteria, as to whether it should set an extra objective variable. If the machine learning algorithm 20 sets an extra objective variable and calculates importance for it (i.e., step S140; YES), the algorithm moves the process to step S120. If the machine learning algorithm 20 does not set an extra objective variable and calculate importance for it (i.e., step S140; NO), the algorithm moves the process to step S150.

The predetermined criteria for the machine learning algorithm 20 to make a decision as to whether it should set an extra objective variable may be acquired by the algorithm presenting the deduced highly critical items HC to the user and receiving the user's response to it.

The predetermined criteria for the machine learning algorithm 20 to make a decision as to whether it should set an extra objective variable may be an automatic decision based on the difference between the item ranked first in terms of importance and that ranked second in terms of importance.

(Step S150) The machine learning algorithm 20 performs a support vector regression analysis with the deduced highly critical items HC to obtain suitable manufacturing conditions.

(Step S160) The machine learning algorithm 20 determines modified conditions.

The machine learning algorithm 20 may be configured to determine the modified conditions by presenting the results of the support vector regression analysis in step S150 to the user and receiving the user's response to it.

[Summary of the Embodiment]

According to this embodiment described above, the method for optimizing manufacturing conditions for a polyarylene sulfide resin composite includes executing a machine learning algorithm 20 using a data set DS to determine items highly important for changes in a characteristic value for a target item for improved characteristics. The data set DS includes manufacturing conditions data CD and measured characteristics data MD. The manufacturing conditions data CD includes at least the ingredients for the polyarylene sulfide resin composite, mixing conditions, and polymer melt temperature during the melt kneading. The measured characteristics data MD includes the characteristic value item of at least the impact resistance of the polyarylene sulfide resin composite when produced under the manufacturing conditions specified by the manufacturing conditions data CD.

In the production of a polyarylene sulfide resin composite, the process of determining which parameters should be controlled for improved characteristic values has relied on skilled engineers' experience and intuition due to a myriad of controllable parameters in the manufacturing conditions. This embodiment helps optimize the control parameters without relying on engineers' experience and intuition because it provides an easy way to deduce items highly important

for changes in a characteristic value for a target item for improved characteristics.

According to this embodiment described above, furthermore, the machine learning algorithm 20 is a random forest-based algorithm. The machine learning algorithm 20, moreover, determines the items highly important for changes in the characteristic value for the target item for improved characteristics by calculating the importance of each of the multiple items included in the manufacturing conditions data CD and the measured characteristics data MD. Specifically, the machine learning algorithm 20 analyzes all of control, measured, and characteristics variables in the data set DS, calculates their importance, and deduces highly critical items HC based on the calculated importance. Even if any item in measured characteristics data MD is important that is not controlled as a control parameter but rather changes as a result of control, therefore, this embodiment helps choose such a spontaneously changing parameter as a highly critical item HC.

According to this embodiment described above, furthermore, the manufacturing conditions data CD includes the manufacturing conditions items CD of control variables, which are to be controlled by the production system with which the polyarylene sulfide resin composite is manufactured, and measured variables, which are not to be controlled by the production system. Even if any parameter is important that is not controlled as a control parameter but rather changes spontaneously, therefore, this embodiment helps choose such a spontaneously changing parameter as a highly critical item HC.

According to this embodiment described above, furthermore, the measured variables include in-cylinder temperatures at multiple points of a cylinder 13. In other words, the machine learning algorithm 20 deduces items highly important for changes in the characteristic value for the target item for improved characteristics with in-cylinder temperatures (polymer melt temperatures during the melt kneading) at multiple points of a cylinder 13 as measured variables. This embodiment, therefore, helps the machine learning algorithm 20 deduce highly critical items HC with high accuracy.

According to this embodiment described above, furthermore, of the in-cylinder temperatures (polymer melt temperatures during the melt kneading) at multiple points of the cylinder 13, which are measured variables, ones on the upstream side of the cylinder 13 have higher importance than ones on the downstream side. This embodiment, therefore, helps assign an important parameter as a control parameter, although it has been impossible to identify critical parameters without relying on skilled engineers' experience and intuition.

According to this embodiment described above, furthermore, the machine learning algorithm 20 sets any of the deduced highly critical items HC as a new objective variable and finds out which item is highly important for changes in the characteristic value for the objective variable. The machine learning algorithm 20, therefore, is able to find out which parameter contributes to the most critical parameter. This ability to find out which parameter contributes to a parameter determined to be critical allows the machine learning algorithm 20 to select parameters required for improvements in the characteristic value for the target item for improved characteristics more accurately.

According to this embodiment described above, furthermore, a regression operation using the data set DS is performed with the deduced highly critical items HC as analytical axes to estimate correspondence between changes in the highly critical items HC and changes in the characteristic value for the objective variable. This embodiment, therefore, provides an easy way to select parameters required for improvements in the characteristic value for the target item for improved characteristics.

It should be noted that in this embodiment described above, all or a subset of the functions of each component of the machine learning algorithm 20 may be fulfilled by recording a program for fulfilling such functions in a computer-readable recording medium and having a computer system load and execute the program recorded in this recording medium. The "computer system" in this context includes the OS and hardware, including peripherals.

The "computer-readable recording medium," furthermore, refers to a portable medium, such as a magneto-optical disk, ROM, or a CD-ROM, or a built-in memory of a computer system, such as a hard disk. The "computer-readable recording medium" may further include those that dynamically hold the program for a short period of time, such as communication lines used when the program is sent via the Internet or any other network, and those that hold the program for a given length of time, such as volatile memory inside a computer system that serves as the server or client in such a process of sending the program. The program, furthermore, may be one for fulfilling a subset of the functions or may be one that fulfills the functions in concert with a program already recorded in the computer system.

The following describes a method according to an embodiment of the present invention for manufacturing a resin composite.

<<Resin Composite>>

The method according to an embodiment for manufacturing a resin composite is a method for manufacturing a polyarylene sulfide resin composite containing a polyarylene sulfide resin (A) and a thermoplastic elastomer (B), the method including a step of melting and kneading a raw-material polyarylene sulfide resin (A) and a raw-material thermoplastic elastomer (B) with an extruder. The shear rate the extruder generates by rotating its screw(s) with respect to the inner wall of its cylinder is between 1000 and 6500 $s^{-1}$, and the preset temperature of the cylinder is below 300°C

over a length of the cylinder equal to or longer than 3/15 of the whole length of the cylinder.

The method according to an embodiment for manufacturing a polyarylene sulfide resin composite herein may be referred to simply as "the manufacturing method according to an embodiment" or "the manufacturing method." The polyarylene sulfide resin composite according to an embodiment, furthermore, may be referred to simply as "the resin composite according to an embodiment" or "the resin composite."

In the manufacturing method according to an embodiment, the raw-material polyarylene sulfide resin (A) and the raw-material thermoplastic elastomer (B), which are raw materials for the polyarylene sulfide resin composite and the thermoplastic elastomer (B), can be put into the extruder and melted and kneaded with the extruder in such a manner that the percentage of the elastomer (B) will be between 5% and 30% by mass of the total mass (100% by mass) of the resin composite.

In the manufacturing method according to an embodiment, the raw-material polyarylene sulfide resin (A) and the raw-material thermoplastic elastomer (B) may be preliminarily dry-blended together in a mixer before their melt kneading to give a mixture containing the raw-material polyarylene sulfide resin (A) and the raw-material thermoplastic elastomer (B). An example of a mixture is one containing polyarylene sulfide resin particles (a) and thermoplastic elastomer particles (b), both described later herein. Putting such a mixture into a melt kneader and melting and kneading it is advantageous because it helps disperse the thermoplastic elastomer (B) well.

An example of how to preliminarily dry-blend the raw-material polyarylene sulfide resin (A) and the raw-material thermoplastic elastomer (B) is by mixing them together using a mixer, such as a Nauta mixer, tumbler, or Henschel mixer. If a Nauta mixer, for example, is used to mix them together, an example of operating conditions is a rotational frequency of the screw inside the Nauta mixer in a range of 50 rpm to 80 rpm and an orbital frequency of the screw in the range of 1.5 rpm to 2.5 rpm.

The process of melt kneading, performed with the extruder, in the manufacturing method according to an embodiment is one in which the raw materials are melted and kneaded with the shear rate the extruder generates by rotating its screw(s) with respect to the inner wall of its cylinder being between 1000 and 6500 $s^{-1}$. Preferably, the raw materials are melted and kneaded with the shear rate between 1500 and 4800 $s^{-1}$, more preferably with the shear rate between 3000 and 4000 $s^{-1}$.

In this context, the shear rate is a value determined according to the following equation.

$$\text{Shear rate } (\gamma) = (\pi \times D \times N)/H$$

Since 60 rpm is 1 $s^{-1}$, converting this as in the following equation will give a shear rate in the unit of $s^{-1}$.

$$\text{Shear rate } (\gamma) = [\pi \times D \times (N/60)]/H$$

[D represents the screw diameter (mm), N represents the screw speed (rpm), and H represents the tip clearance (mm).]

Fig. 7 is a schematic diagram illustrating an example of a structure of a resin composite according to an embodiment.

Fig. 7 illustrates a resin composite in which the polyarylene sulfide resin (A) is the matrix polymer with the thermoplastic elastomer (B) dispersed therein. Kneading at a shear rate equal to or faster than any of the above lower limits helps ensure good dispersion of the thermoplastic elastomer (B).

A possible measure of good dispersion of the thermoplastic elastomer (B) is the average diameter of dispersed particles of the thermoplastic elastomer (B) in the resin composite according to an embodiment. The smaller this average diameter of dispersed particles is, the better the dispersion of the thermoplastic elastomer (B) is. Kneading at a shear rate equal to or faster than any of the above lower limits, furthermore, helps prevent the thermoplastic elastomer (B) from degrading or depolymerizing, thereby helping improve the impact resistance of the resin composite according to an embodiment.

The average diameter of dispersed particles of the thermoplastic elastomer (B) in the resin composite can be determined by the following method.

The resin composite of interest is put into an injection molding machine as a molding material and shaped into an ISO 3167 type-A multipurpose test specimen (shaped article). Then this multipurpose test specimen is cut at the middle in the longitudinal direction, and the cross-section is polished. The cut piece is immersed in xylene and sonicated at a temperature of 50°C, and the dispersed thermoplastic elastomer (B) on the cross-section is removed by extraction with xylene. Then the specimen is dried at 130°C for 2 hours, and the cross-section is observed and imaged by SEM. The image has void phases corresponding to the areas in which the thermoplastic elastomer (B) has been removed, displayed in round shapes in low-brightness black. All such black round objects seen in the image’s field of view (n =

300 or more) are measured on image analysis software for their equivalent circular diameter (calculated diameter of a perfect circle equivalent to the area of the round object), and the average, given by dividing the total by the number of round objects, is reported as the average diameter of dispersed particles of the thermoplastic elastomer (B).

Preferably, the average diameter of dispersed particles of the thermoplastic elastomer (B) in the resin composite according to an embodiment is 0.20 μm or less, more preferably 0.01 μm or more and 0.18 μm or less, even more preferably 0.05 μm or more and 0.17 μm or less.

A resin composite in which the average diameter of dispersed particles of the thermoplastic elastomer (B) is in any of these numerical ranges is advantageous as it tends to exhibit excellent impact resistance.

In the manufacturing method according to an embodiment, the screw speed of the extruder that generates the aforementioned shear rate may be, for example, between 330 and 2000 rpm, may be between 500 and 1500 rpm, or may be between 970 and 1250 rpm.

The melt kneading, performed with the extruder, in the manufacturing method according to an embodiment, furthermore, is done with the preset temperature of the extruder's cylinder being below 300°C over a length of the cylinder equal to or longer than 3/15 of the whole length of the cylinder. Preferably, this preset temperature is 220°C or above and below 300°C, more preferably 230°C or above and 295°C or below, even more preferably 250°C or above and 290°C or below, in particular 260°C or above and 285°C or below.

An example of a preset temperature of the cylinder is the preset temperature of a barrel surrounding the cylinder.

Providing a region in which the preset temperature is in any of these numerical ranges, or "low-temperature region," will prevent thermal degradation of the resin composite and improve the dispersion of the thermoplastic elastomer (B) at the same time, thereby helping improve the impact resistance of the resin composite according to an embodiment.

To this end, it is preferred to allow the low-temperature region a certain length (3/15 or longer). It is also preferred to set an upper limit to the length of the low-temperature region and provide a region in which the temperature is higher than in the low-temperature region, or "high-temperature region," besides the region defined as the low-temperature region because it helps further improve the Charpy impact value of the resin composite.

The low-temperature region is a region having a length equal to or longer than 3/15 of the whole length of the extruder's cylinder. It may be a region having a length of 3/15 or more and 15/15 or less, a region having a length of 4/15 or more and 13/15 or less, or a region having a length of 5/15 or more and 12/15 or less of the whole length of the cylinder.

The low-temperature region may be continuous or discontinuous. If the low-temperature region is discontinuous, the total length of the regions that meet the definition of a low-temperature region can be used as that of the low-temperature region.

Preferably, the low-temperature region is a continuous region. The low-temperature region may be a region having a continuous length equal to or longer than 3/15, a region having a continuous length of 3/15 or more and 15/15 or less, a region having a continuous length of 4/15 or more and 13/15 or less, or a region having a continuous length of 5/15 or more and 12/15 or less of the whole length of the extruder's cylinder.

It should be noted that the whole length of the cylinder excludes the die and head sections of the extruder.

If an upper limit is set to the length of the low-temperature region, the temperature in the rest of the cylinder may be set to any value exceeding the preset temperature of the barrel in the low-temperature region, i.e., a predetermined preset value below 300°C.

For example, the extruder's cylinder has a low-temperature region with a preset temperature of below 300°C over a length equal to or longer than 3/15 of its whole length, and in the high-temperature region, which is the rest, the preset temperature of the cylinder may be 300°C or above and 370°C or below;

the extruder's cylinder may have a low-temperature region with a preset temperature of 230°C or above and 295°C or below over a length equal to or longer than 3/15 of its whole length, and in the high-temperature region, which is the rest, the preset temperature of the cylinder may be above 295°C and 360°C or below;

the extruder's cylinder may have a low-temperature region with a preset temperature of 250°C or above and 290°C or below over a length equal to or longer than 3/15 of its whole length, and in the high-temperature region, which is the rest, the preset temperature of the cylinder may be above 290°C and 340°C or below; or

the extruder's cylinder may have a low-temperature region with a preset temperature of 260°C or above and 285°C or below over a length equal to or longer than 3/15 of its whole length, and in the high-temperature region, which is the rest, the preset temperature of the cylinder may be above 285°C and 320°C or below.

Alternatively, if the extruder's cylinder has a low-temperature region with a preset temperature of below 300°C over a length equal to or longer than 3/15 of its whole length, the preset temperature of the cylinder in the high-temperature region, which is the rest, may be, for example, 300°C or above and 370°C or below, may be 300°C or above and 360°C or below, may be 300°C or above and 340°C or below, or may be 300°C or above and 320°C or below.

If the manufacturer makes the preset temperature of the cylinder vary, the difference between the cylinder's

maximum and minimum preset temperatures in a region with preset temperatures of the cylinder of 220°C or above may be, for example, between 10°C and 150°C, may be between 30°C and 120°C, or may be between 50°C and 100°C.

The difference between the cylinder's maximum preset temperature in the low-temperature region and minimum preset temperature in the high-temperature region may be, for example, between 5°C and 150°C, may be between 7°C and 100°C, or may be between 10°C and 30°C.

Temperature variations within the low-temperature region are also allowed. If the manufacturer makes the temperature vary within the low-temperature region, the difference between the cylinder's maximum and minimum preset temperatures in the low-temperature region may be, for example, between 5°C and 80°C, may be between 10°C and 70°C, or may be between 20°C and 60°C, provided that the cylinder's preset temperatures there are 220°C or above.

Interestingly, in such a form of the method, in which the melt kneading temperature varies in different regions of the cylinder, providing the low-temperature region on the upstream side, on which the raw materials for the resin composite are introduced (the cylinder's region that lies closer to the feedstock inlet when the cylinder's whole length is bisected), is more effective in improving the impact resistance of the resin composite according to an embodiment.

For example, when the whole length of the extruder's cylinder is divided into fifteen equal segments, the low-temperature region may be set to include at least the third to fifth segments out of the fifteen, may be set to include at least the second to sixth segments out of the fifteen, or may be set to include at least the first to seventh segments out of the fifteen as counted from the end on the feedstock inlet side (upstream side), on which the ingredients for the resin composite are introduced.

The inventors presume the following is the reason why it is better to set the low-temperature region on the upstream side of the extruder. Admittedly, the first half of the extruder is endothermic during the polymer melting, but this region, the inventors believe, produces more frictional heat than needed because the raw materials mix together there. For this reason, the inventors believe, an arrangement to make the temperature lower in the upstream region, or on the feedstock inlet side, will limit thermal degradation of the resin composite, thereby contributing to improving the Charpy impact value.

Kneading at a shear rate in any of the above ranges tends to make the cylinder's actual inner temperature higher than the preset temperature because of shear heating. Preferably, the maximum temperature of the polymer melt kneaded inside the cylinder in the low-temperature region is 250°C or above and below 320°C, more preferably 270°C or above and 315°C or below, even more preferably 280°C or above and 310°C or below.

The maximum temperature of the polymer melt kneaded inside the cylinder may be that in the high-temperature region, preferably is above 315°C and 400°C or below. For effective control of the degradation of the thermoplastic elastomer, it is more preferred that this maximum temperature be 315°C or above and 350°C or below, even more preferably 315°C or above and 330°C or below.

The extruder can be, for example, a single-screw extruder, which has one screw for the extrusion inside its cylinder, or a twin-screw extruder, which has two such screws. A method in which a twin-screw extruder is used, however, is preferred because this type of extruder is highly efficient in kneading all ingredients for the polyarylene sulfide resin composite.

It is particularly preferred to use a co-rotating twin-screw extruder having kneading disks, which are disks for kneading purposes.

Preferably, the screw length (L)/screw diameter (D) value of the extruder is between 40 and 200, more preferably between 50 and 150, even more preferably between 70 and 120. When this L/D value is equal to or larger than any of the lower limits, it is easier to obtain a polyarylene sulfide resin composite that exhibits excellent impact resistance because in that case temperature control during the kneading is easier. When this L/D value is equal to or smaller than any of the upper limits, the extruder is highly efficient in producing the resin composite.

When it comes to operating conditions in melt kneading with the twin-screw extruder, an example is a method in which the raw materials are melted and kneaded under conditions under which the ratio between the rate of ejection of the resin component (kg/h) and the screw speed (rpm) (rate of ejection/screw speed) is between 0.001 and 0.01 (kg/h·rpm). Production under such conditions leads to better dispersion of the thermoplastic elastomer (B) in the polyarylene sulfide resin (A).

<Polyarylene Sulfide Resin (A)>

The polyarylene sulfide resin (A) used in the manufacturing method according to an embodiment is one having a resin structure whose repeating unit is a structure formed by an aromatic ring and a sulfur atom bound together. A specific example is a resin whose repeating unit is a structural moiety represented by structural formula (1) below.

[Chem. 1]

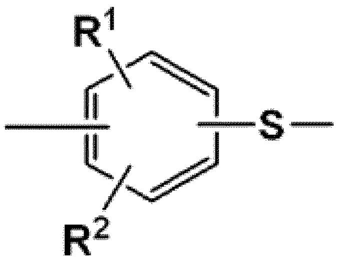

Structural formula (1)

(In the formula, $R^1$ and $R^2$ each independently represent a hydrogen atom or a C1 to C4 alkyl, nitro, amino, phenyl, methoxy, or ethoxy group.)

For the structural moiety represented by structural formula (1) above, it is particularly preferred, in terms of the mechanical strength of the polyarylene sulfide resin (A), that $R^1$ and $R^2$ in the formula be hydrogen atoms. Examples in that case include the para-substituted one, represented by structural formula (2) below, and the meta-substituted one, represented by structural formula (3) below.

[Chem. 2]

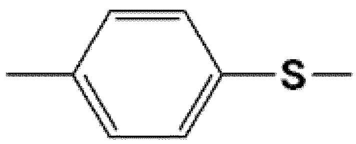

Structural formula (2)

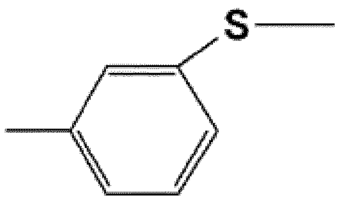

Structural formula (3)

Of these, the structure in which the aromatic ring in the repeating unit is para-substituted with the sulfur atom, represented by structural formula (2) above, is particularly preferred in terms of the heat resistance and crystallinity of the polyarylene sulfide resin (A).

The polyarylene sulfide resin (A), furthermore, does not need to be formed solely by the structural moiety represented by structural formula (1) above. It may contain any one or more of the structural moieties represented by structural formulae (4) to (7) below up to 30 mol% when the total percentage including the structural moiety represented by structural formula (1) above is assumed to be 100 mol%.

[Chem. 3]

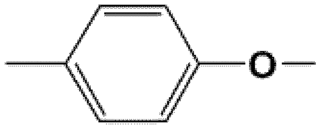

Structural formula (4)

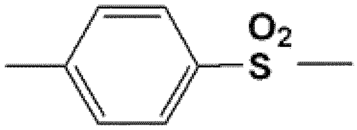

Structural formula (5)

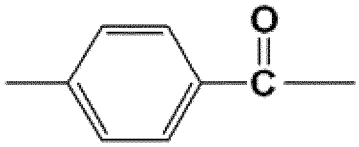

Structural formula (6)

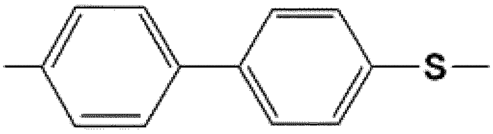

Structural formula (7)

The presence of any one or more of the structural moieties represented by structural formulae (4) to (7) above up to 10 mol% is particularly preferred in terms of the heat resistance and mechanical strength of the polyarylene sulfide resin (A). If the polyarylene sulfide resin (A) contains any one or more of the structural moieties represented by structural formulae (4) to (7) above, its/their form of binding may be either that of a random copolymer or that of a block copolymer.

The polyarylene sulfide resin (A) as described above can be, for example, a crosslinked polyarylene resin or a so-called "linear" polyarylene sulfide resin, which has a substantially linear structure. Such a polyarylene sulfide resin (A) can be produced by allowing sodium sulfide and p-dichlorobenzene to react in an amide solvent, such as N-methylpyrrolidone or dimethylacetamide, or in a sulfone solvent, such as sulfolane; this method is superior in industrial productivity by virtue of the ease of control of the reaction.

Preferably, the raw-material polyarylene sulfide resin (A) is polyarylene sulfide resin particles (a) having a diameter in the range of 1.0 mm to 3.0 mm as a volume-average diameter. When the volume-average diameter of the polyarylene sulfide resin particles (a) is 1.0 mm or more, the polyarylene sulfide resin particles (a) do not reaggregate easily, therefore are easy to handle, and easily mix with thermoplastic elastomer particles (b) to homogeneity. When the polyarylene sulfide resin particles (a) are particles having a volume-average diameter of 3.0 mm or less, their effect of strengthening the polyarylene sulfide resin composite improves because in that case they mix homogeneously with thermoplastic elastomer particles (b) easily. Of such particles, it is more preferred that the raw-material resin be polyarylene sulfide resin particles (a) having a volume-average diameter in the range of 1.5 mm to 2.5 mm in particular.

Such polyarylene sulfide resin particles (a) having a volume average diameter in the range of 1.0 mm to 3.0 mm can be produced by, for example, method (I) or (II) below.

(I) After the end of the polymerization of the polyarylene sulfide resin (A) as described above, the reaction solution of the polyarylene sulfide resin (A) is cooled, then the resin is washed several times with water or warm water, dried, and the resulting particles of the polyarylene sulfide resin (A) are packed together by compression using a press, such as a belt press machine, to give a solid plate, and then this plate is pulverized to give polyarylene sulfide resin particles (a) having a volume-average diameter in the range of 1.0 mm to 3.0 mm.

(II) After the end of the polymerization of the polyarylene sulfide resin (A), water is added to the reaction solution of the polyarylene sulfide resin (A) before cooling, or with the polyarylene sulfide resin (A) dissolved in the reaction solvent, to give polyarylene sulfide resin particles (a) having a volume-average diameter in the range of 1.0 mm to 3.0 mm.

Preferably, the polyarylene sulfide resin (A) is one having a carboxyl group, as a functional group having an active hydrogen atom, in its molecular framework because this helps boost the reactivity of the polyarylene sulfide resin (A). Specifically, it is preferred that the carboxyl content of the polyarylene sulfide resin (A) as measured by neutralization titration be in the range of 10 μmol/g to 200 μmol/g, more preferably in the range of 10 μmol/g to 100 μmol/g. When

this carboxyl content of the polyarylene sulfide resin (A) as measured by neutralization titration is 10 μmol/g or more, the reactivity of the polyarylene sulfide resin (A) is improved. When it is 200 μmol/g or less, it is easy to control the reactivity of the polyarylene sulfide resin (A).

An example of how to produce such a polyarylene sulfide resin (A) having a carboxyl group, as a functional group having an active hydrogen atom, in its molecular framework is by cooling the polyarylene sulfide resin (A) to room temperature after the end of its polymerization, washing it with water, then isolating the polyarylene sulfide resin (A) by filtration, treating the residue with an acid, and then washing it with water. Preferred options for the acid include acetic acid, hydrochloric acid, sulfuric acid, phosphoric acid, silicic acid, carbonic acid, oxalic acid, and propionic acid as they efficiently reduce the quantity of residual metal ions without decomposing the polyarylene sulfide resin (A). Of these, it is more preferred to use acetic acid or hydrochloric acid in particular.

Preferably, furthermore, the polyarylene sulfide resin (A) according to an embodiment is one whose melt viscosity measured at 300°C is in the range of 60 Pa·s to 240 Pa·s. When the melt viscosity of the polyarylene sulfide resin (A) is 60 Pa·s or more, the rigidity of the polyarylene sulfide resin composite improves. When the melt viscosity of the polyarylene sulfide resin (A) is 240 Pa·s or less, it is easy to limit heat production from the polyarylene sulfide resin composite under high shear conditions. In such ranges, it is particularly preferred, in terms of the balance between the strengthening by the addition of the thermoplastic elastomer (B) and the flowability of the polyarylene sulfide resin composite, that the melt viscosity of the polyarylene sulfide resin (A) be in the range of 80 Pa·s to 180 Pa·s.

In this context, the melt viscosity of the polyarylene sulfide resin (A) measured at 300°C as described above represents the melt viscosity (Pa·s) of the polyarylene sulfide resin (A) measured using an SPSJ flow tester (developed by the Society of Polymer Science, Japan; a constant-load flow tester) with a 10-mm long and 1-mm diameter orifice after 6 minutes of holding at 300°C under a test load of 50 kg.

Preferably, the percentage of the polyarylene sulfide resin (A) in the resin composite according to an embodiment is between 50% and 95% by mass, more preferably between 70% and 90% by mass, even more preferably between 75% and 85% by mass of the total mass (100% by mass) of the polyarylene sulfide resin composite. The upper and lower limits of these numerical ranges for the percentage of the polyarylene sulfide resin (A) provided by way of example can be paired in any combination.

<Thermoplastic Elastomer (B)>

Preferably, the thermoplastic elastomer (B) used in the manufacturing method according to an embodiment is, for example, one having a melting point of 300°C or below and rubber elasticity at room temperature. Such a thermoplastic elastomer (B) is advantageous in that it is highly effective in improving the impact resistance of the polyarylene sulfide resin composite. Preferably, furthermore, the thermoplastic elastomer (B) is a polyolefin or nitrile thermoplastic elastomer, more preferably a polyolefin thermoplastic elastomer, because such elastomers are superior in heat resistance.

An example of a polyolefin thermoplastic elastomer is a thermoplastic elastomer containing an olefin-derived unit. Preferably, the olefin is an α-olefin. Preferably, the polyolefin thermoplastic elastomer is one having, in its molecular framework, one or more functional groups or structures selected from the group consisting of a hydroxy group, a carboxyl group, an amino group, a mercapto group, an epoxy group, an acid anhydride structure, an ester structure, and an isocyanate group because such an elastomer is superior in reactivity and miscibility with the polyarylene sulfide resin (A). Of such polyolefin thermoplastic elastomers, those having a carboxyl group, epoxy group, acid anhydride structure, or ester structure in their molecular framework in particular are more preferred because they help obtain a homogeneously mixed polyarylene sulfide resin composite with their higher reactivity and improved miscibility with the polyarylene sulfide resin (A).

In particular, glycidyl-modified polyolefin thermoplastic elastomers, having an epoxy group in their molecular framework, allow the manufacturer to impart excellent impact resistance to the resin composite. By known methods, however, it has been difficult to disperse an increased proportion of such an elastomer well in a resin composite.

In the manufacturing method according to an embodiment, by contrast, the thermoplastic elastomer (B) is dispersed well, even if it is a glycidyl-modified polyolefin thermoplastic elastomer. The manufacturer, therefore, can produce a polyarylene sulfide resin composite that exhibits excellent impact resistance.

Such a polyolefin thermoplastic elastomer having a carboxyl group, epoxy group, acid anhydride structure, or ester structure in its molecular framework can be obtained via, for example, copolymerization of an α-olefin with a polymerizable vinyl compound having a carboxyl group, epoxy group, acid anhydride structure, or ester structure in its molecular framework. Examples of α-olefins include C2 to C8 α-olefins, such as ethylene, propylene, and butene.

A polyolefin thermoplastic elastomer having a carboxyl group in its molecular framework can be obtained via, for example, copolymerization of an α,β-unsaturated carboxylic acid, such as acrylic acid or methacrylic acid, or maleic, fumaric, itaconic, or any other C4 to C10 unsaturated dicarboxylic acid with an α-olefin as described above.

A polyolefin thermoplastic elastomer having an epoxy group in its molecular framework can be obtained via copolymerization of glycidyl acrylate or glycidyl methacrylate, for example, with an α-olefin as described above.

A polyolefin thermoplastic elastomer having an acid anhydride structure in its molecular framework can be obtained via copolymerization of an α,β-unsaturated dicarboxylic anhydride, such as an anhydride of maleic, fumaric, itaconic, or any other C4 to C10 unsaturated dicarboxylic acid, with an α-olefin as described above.

A polyolefin thermoplastic elastomer having an ester structure in its molecular framework can be obtained via copolymerization of an alkyl ester of an α,β-unsaturated carboxylic acid, such as an acrylate or methacrylate, or a monoester or diester of maleic, fumaric, itaconic, or any other C4 to C10 unsaturated dicarboxylic acid with an α-olefin as described above.

The manufacturer can use a copolymer containing multiple ones of two or more kinds of these functional groups or structures together. An example of a preferred one is a terpolymer of an α-olefin, an acrylate, and glycidyl methacrylate.

Preferably, the thermoplastic elastomer (B) contains 40% to 95% by mass, more preferably 50% to 90% by mass, even more preferably 60% to 80% by mass of α-olefin-derived units based on the total mass (100% by mass) of the units forming the thermoplastic elastomer (B).

Preferably, the thermoplastic elastomer (B) contains 0.1% to 30% by mass, more preferably 0.5% to 15% by mass, even more preferably 1% to 7% by mass of glycidyl (meth)acrylate-derived units based on the total mass (100% by mass) of the units forming the thermoplastic elastomer (B) .

Preferably, the thermoplastic elastomer (B) contains 0.1% to 50% by mass, more preferably 3% to 40% by mass, even more preferably 10% to 35% by mass of methyl acrylate-derived units based on the total mass (100% by mass) of the units forming the thermoplastic elastomer (B).

An example of such a copolymer is one that contains:

0.1% to 30% by mass of glycidyl (meth)acrylate-derived units; and
0.1% to 50% by mass of methyl acrylate-derived units,
both based on the total mass (100% by mass) of the units forming the thermoplastic elastomer (B).

An example of such a copolymer is one that contains:

40% to 95% by mass of α-olefin-derived units;
0.1% to 30% by mass of glycidyl (meth)acrylate-derived units; and
0.1% to 50% by mass of methyl acrylate-derived units,
all based on the total mass (100% by mass) of the units forming the thermoplastic elastomer (B).

As for nitrile thermoplastic elastomers, an example is a copolymer of an unsaturated nitrile and a conjugated diene. The unsaturated nitrile is, for example, acrylonitrile or methacrylonitrile, and the conjugated diene is, for example, a diene like 1,3-butadiene, 2-methyl-1,3-butadiene, 2,3-dimethyl-1,3 butadiene, or 1,3-pentadiene. Of such copolymers, acrylonitrile-butadiene copolymers are particularly preferred. A hydrogenated nitrile thermoplastic elastomer is more preferred, which is derived by hydrogenating a subset or all of the double bonds of the conjugated diene and, therefore, has improved heat resistance while maintaining the triple bond of the nitrile group.

Preferably, the hydrogenated nitrile thermoplastic elastomer is one having, in its molecular framework, one or more functional groups selected from the group consisting of a vinyl group, a hydroxy group, a carboxyl group, an acid anhydride structure, a glycidyl group, an amino group, an isocyanate group, a mercapto group, an oxazoline group, an isocyanurate group, and a maleimide group because such an elastomer is superior in reactivity and miscibility with the polyarylene sulfide resin (A). Of such hydrogenated nitrile thermoplastic elastomers, those having a carboxyl group are particularly preferred as they are superior in heat resistance and reactivity.

Preferably, a raw-material thermoplastic elastomer (B) that can be used in the manufacturing method according to an embodiment is thermoplastic elastomer particles (b) having a volume-average diameter in the range of 0.1 mm to 3.0 mm. When the volume-average diameter of the thermoplastic elastomer particles (b) is 0.1 mm or more, the thermoplastic elastomer particles (b) do not reaggregate easily, and therefore are easy to handle, by virtue of their small specific surface area. It is, therefore, easy to add a predetermined quantity of thermoplastic elastomer particles (b). When the thermoplastic elastomer particles (b) are particles having a volume-average diameter of 3.0 mm or less, they produce their effect of strengthening the polyarylene sulfide resin composite well because they mix homogeneously with the polyarylene sulfide resin (A) easily. Of such volume-average diameters, it is particularly preferred, in terms of the ease of operational handling, the ease of homogeneous mixing, and the balance between the effectiveness in improving impact resistance and that in improving flexural strength of the thermoplastic elastomer particles (b), that the volume-average diameter of the thermoplastic elastomer particles (b) be in the range of 0.3 mm to 2.0 mm.

Examples of how to produce such thermoplastic elastomer particles (b) having a diameter in the range of 0.1 mm to 3.0 mm as a volume-average diameter include producing them by shredding thermoplastic elastomer particles having a volume-average diameter exceeding 3.0 mm into smaller pieces using a cutting machine, and freeze-grinding such thermoplastic elastomer particles having a volume-average diameter exceeding 3.0 mm. An example of a method

for freeze grinding is to freeze the particles with, for example, dry ice or liquid nitrogen and then grind the frozen particles using an ordinary grinder, such as a hammer mill, cutter mill, or millstones. Of these methods for producing thermoplastic elastomer particles (b), freeze grinding is particularly preferred because it is an easier way to produce the thermoplastic elastomer particles (b).

The percentage of the thermoplastic elastomer (B) in the resin composite according to an embodiment is between 5% and 30% by mass, preferably between 10% and 28% by mass, more preferably between 15% and 25% by mass of the total mass (100% by mass) of the polyarylene sulfide resin composite. The upper and lower limits of these numerical ranges for the percentage of the thermoplastic elastomer (B) provided by way of example can be paired in any combination.

From another perspective, it is preferred that the proportion of the thermoplastic elastomer (B) be between 5 and 30 parts by mass, more preferably between 10 and 28 parts by mass, even more preferably between 15 and 25 parts by mass with respect to the total amount (100 parts by mass) of the polyarylene sulfide resin (A) and the thermoplastic elastomer (B) in the polyarylene sulfide resin composite.

By virtue of the percentage of the thermoplastic elastomer (B) being equal to or higher than any of the above lower limits, the elastomer's effect of improving the impact resistance of the polyarylene sulfide resin composite is produced well. By virtue of the percentage of the thermoplastic elastomer (B) being equal to or lower than any of the above upper limits, gas production during the molding of the polyarylene sulfide resin composite will be reduced effectively.

When one tries to add an amount of thermoplastic elastomer (B) equal to or larger than any of the above lower limits by known methods, it has been difficult to disperse the elastomer component in the resin composite with high dispersibility. The cause of this is unclear, but the inventors believe this is because more energy is needed to disperse the elastomer with increasing percentage of the elastomer component, and because the frequency of contact between half-dispersed elastomer molecules becomes higher at the same time.

In the manufacturing method according to an embodiment, by contrast, the thermoplastic elastomer (B) is dispersed well, even if its percentage is equal to or higher than any of the above lower limits. The manufacturer, therefore, can produce a polyarylene sulfide resin composite that exhibits excellent impact resistance.

Besides the polyarylene sulfide resin (A) and the thermoplastic elastomer (B), the resin composite according to an embodiment can contain other, optional ingredients unless their total amounts (% by mass) exceed 100% by mass. Besides the ingredients described above, the resin composite according to an embodiment can contain an epoxysilane coupling agent (C). This is advantageous in that the thermoplastic elastomer (B) is dispersed more uniformly by virtue of excellent reactivity of the epoxysilane coupling agent with the polyarylene sulfide resin (A) and the thermoplastic elastomer (B). The strengthening of the polyarylene sulfide resin composite, furthermore, is more significant as a result of improved adhesion of the polyarylene sulfide resin (A) and the thermoplastic elastomer (B) at their interfaces.

Preferably, the epoxysilane coupling agent (C) is a silane compound having a structure in which a glycidoxyalkyl, 3,4-epoxycyclohexylalkyl, or any other epoxy-containing group having a C1 to C4 linear alkyl group, two or more methoxy groups, and an ethoxy group are bound to a silicon atom.

Specific examples of such epoxysilane coupling agents (C) include γ-glycidoxypropyltrimethoxysilane, β-(3, 4-epoxycyclohexyl)ethyltrimethoxysilane, γ-glycidoxypropyltriethoxysilane, and epoxy silicone oils.

An example of an epoxy silicone oil is a compound having a polyalkyleneoxy group formed by two to six repeating units each being a C2 to C6 alkoxy group.

Of such epoxysilane coupling agents (C), glycidoxyalkyltrialkoxysilane compounds, typified by γ-glycidoxypropyltrimethoxysilane and γ-glycidoxypropyltriethoxysilane, are particularly preferred because they are superior in reactivity with the polyarylene sulfide resin (A) and the thermoplastic elastomer (B).

Preferably, the epoxysilane coupling agent (C) content is in the range of 0.1% by mass to 5% by mass as a percentage to the total mass of the polyarylene sulfide resin composite. When this percentage is 0.1% by mass or more, the miscibility between the polyarylene sulfide resin (A) and the thermoplastic elastomer (B) is better. When this percentage is 5% by mass or less, gas production during melt molding of the polyarylene sulfide resin composite will be reduced. Of such percentages, it is particularly preferred, in terms of the balance between the miscibility of the polyarylene sulfide resin (A) and the thermoplastic elastomer (B) and the volume of gas production during melt molding of the polyarylene sulfide resin composite, that the epoxysilane coupling agent (C) content be in the range of 0.1% by mass to 2% by mass.

In the method according to an embodiment for manufacturing a polyarylene sulfide resin composite, inorganic filler may optionally be added besides the substances described above. Examples of inorganic fillers include fibrous inorganic fillers and non-fibrous inorganic fillers.

Examples of fibrous inorganic fillers include inorganic fibrous substances, which include glass fiber, PAN or pitch carbon fiber, silica fiber, zirconia fiber, boron nitride fiber, silicon nitride fiber, boron fiber, aluminum borate fiber, potassium titanate fiber, and fibrous forms of stainless steel, aluminum, titanium, copper, brass, and other metals, and organic fibrous substances, such as aramid fiber.

Examples of non-fibrous inorganic fillers include silicates, such as mica, talc, wollastonite, sericite, kaolin, clay,

bentonite, asbestos, alumina silicate, zeolite, and pyrophyllite, carbonates, such as calcium carbonate, magnesium carbonate, and dolomite, sulfates, such as calcium sulfate and barium sulfate, metal oxides, such as alumina, magnesium oxide, silica, zirconia, titania, and iron oxide, glass beads, ceramic beads, boron nitride, silicon carbide, and calcium phosphate. One such fibrous or non-fibrous inorganic filler may be used alone, or two or more may be used in combination. It is not critical when such non-fibrous inorganic filler(s) is added, but preferably it is added when the polyarylene sulfide resin (A) and the thermoplastic elastomer (B) are dry-blended with a Nauta mixer.

Preferably, the proportions of the polyarylene sulfide resin (A) and the inorganic filler are in the range of 30 parts by mass to 100 parts by mass/70 parts by mass to 0 parts by mass, as a former/latter ratio, for the melt characteristics of the polyarylene sulfide resin composite and the mechanical properties of articles shaped therefrom. The proportions of fibrous and non-fibrous inorganic fillers can be in any ratio for the mechanical characteristics requirements for shaped articles, but preferably, these proportions are in the range of 20 parts by mass to 100 parts by mass/80 parts by mass to 0 parts by mass as a former/latter ratio.

In the method according to an embodiment for producing a polyarylene sulfide resin composite, it is particularly preferred that the fibrous filler be introduced into the twin-screw extruder from the extruder's side feeder because in this case the fibrous filler disperses well. As for the position of such a side feeder, it is preferred that the distance from the resin inlet to the side feeder of the twin-screw extruder relative to the whole length of the extruder's screws be in the range of 0.1 to 0.6, in the range of 0.2 to 0.4 in particular.

In the manufacturing method according to an embodiment, furthermore, appropriate amounts of additives, such as antioxidants, heat stabilizers for processing heat, plasticizers, release agents, colorants, lubricants, weathering stabilizers, foaming agents, antirusts, and waxes, may be added unless they impair the advantages of the present invention. It is not critical when such additives are added, but preferably, they are added when the polyarylene sulfide resin (A) and the thermoplastic elastomer (B) are dry-blended using a Nauta mixer.

In the manufacturing method according to an embodiment, furthermore, extra resin components, which are neither the polyarylene sulfide resin (A) nor the thermoplastic elastomer (B), may optionally be added according to characteristics requirements. It is not critical when the extra resin components are added, but preferably, they are added when the raw-material polyarylene sulfide resin (A) and the raw-material thermoplastic elastomer (B) are dry-blended using a Nauta mixer. Resin components that can be used include, for example, homopolymers or copolymers of ethylene, butylene, pentene, butadiene, isoprene, chloroprene, styrene, $\alpha$-methylstyrene, vinyl acetate, vinyl chloride, acrylates, methacrylates, (meth)acrylonitrile, and other monomers as well as homopolymers, random or block copolymers, and graft copolymers such as polyurethanes, polyesters, polybutylene terephthalate, polyethylene terephthalate, and other polyesters, polyacetals, polycarbonates, polysulfones, polyarylsulfones, polyethersulfones, polyphenylene ethers, polyether ketones, polyether ether ketones, polyimides, polyamide-imides, polyetherimides, silicone resins, epoxy resins, phenoxy resins, liquid-crystal polymers, and polyarylethers.

Melted and kneaded in such a way, the polyarylene sulfide resin composite can be produced as, for example, pellets. Feeding these pellets of the polyarylene sulfide resin composite to a molding machine and shaping them by melt molding will give the desired shaped article. Examples of methods for melt molding include injection molding, extrusion molding, and compression molding, and the melt molding can be done by any method.

Obtained in such a way, the article shaped from the polyarylene sulfide resin composite contains a thermoplastic elastomer (B) well dispersed therein and is produced by melting and kneading a relatively large amount of thermoplastic elastomer (B). The shaped article, therefore, displays exceptionally high impact resistance.

The polyarylene sulfide resin composites obtained by the manufacturing method according to an embodiment is suitable for use in, for example, vehicle components, which include automotive components and electric or electronic components for use as automotive components, or in vehicle structure applications.

Examples of automotive components include drive components in the engine room (e.g., transmission gears and drive motor components), control components (e.g., the PCU), radiator components (e.g., piping, valves, and pump components), and battery components.

In the method according to an embodiment for producing a resin composite, the manufacturer can produce a polyarylene sulfide resin composite that exhibits excellent impact resistance.

The impact resistance can be the Charpy impact value of an article shaped from the resin composite according to an embodiment.

The Charpy impact value of an article shaped from the resin composite can be determined by the following method.

The resin composite of interest is put into an injection molding machine as a molding material and shaped into a test specimen measuring 80 mm in length × 10.0 mm in width × 4.0 mm in thickness at a preset cylinder temperature of 300°C and a preset mold temperature of 130°C. Then the test specimen is notched ($B_N$: 8 mm) according to ISO 2818 and tested according to ISO 179-1 for the Charpy notched impact value (kJ/$m^2$) at 23°C.

Preferably, the Charpy notched impact value at 23°C of an article shaped from the resin composite according to an embodiment measured as per ISO 179-1 is 40 kJ/$m^2$ or more, more preferably 50 kJ/$m^2$ or more, even more

preferably 60 $kJ/m^2$ or more, still more preferably 62 $kJ/m^2$ or more, in particular 64 $kJ/m^2$ or more.

There is no particular upper limit to this Charpy impact value, but for example, this value may be 70 $kJ/m^2$ or less, may be 69 $kJ/m^2$ or less, or may be 68 $kJ/m^2$ or less.

To take some examples of such numerical ranges, the Charpy notched impact value at 23°C of an article shaped from the resin composite according to an embodiment measured as per ISO 179-1 may be 40 $kJ/m^2$ or more and 70 $kJ/m^2$ or less, may be 50 $kJ/m^2$ or more and 70 $kJ/m^2$ or less, may be 60 $kJ/m^2$ or more and 69 $kJ/m^2$ or less, may be 62 $kJ/m^2$ or more and 68 $kJ/m^2$ or less, or may be 64 $kJ/m^2$ or more and 68 $kJ/m^2$ or less.

As a resin composite according to an embodiment of the present invention, there is provided a resin composite that is a polyarylene sulfide resin composite containing a polyarylene sulfide resin (A) and a thermoplastic elastomer (B). The amount of the thermoplastic elastomer (B) is between 5% and 30% by mass in 100% by mass of the polyarylene sulfide resin composite, and the Charpy notched impact value at 23°C of an article shaped from the resin composite measured as per ISO 179-1 is 40 $kJ/m^2$ or more.

The resin composite according to an embodiment can be produced by the above method for manufacturing a resin composite.

For the Charpy notched impact value at 23°C of an article shaped from the resin composite according to an embodiment measured as per ISO 179-1, examples of numeric values, which are 40 $kJ/m^2$ or more, include those provided above by way of example.

As a resin composite according to an embodiment of the present invention, furthermore, there is provided a polyarylene sulfide resin composite that is a polyarylene sulfide resin composite containing a polyarylene sulfide resin (A) and a thermoplastic elastomer (B). The amount of the thermoplastic elastomer (B) is between 5% and 30% by mass in 100% by mass of the polyarylene sulfide resin composite, and the resin composite has a dispersion structure in which the average diameter of dispersed particles of the thermoplastic elastomer (B) is 0.20 μm or less. A method for producing this resin composite is also provided.

This resin composite can be produced by the method according to an embodiment for manufacturing a resin composite.

Preferably, the average diameter of dispersed particles of the thermoplastic elastomer (B) in the resin composite according to an embodiment is 0.20 μm or less, more preferably 0.01 μm or more and 0.18 μm or less, even more preferably 0.05 μm or more and 0.17 μm or less.

A resin composite in which the average diameter of dispersed particles of the thermoplastic elastomer (B) is in any of these numerical ranges is advantageous as it tends to exhibit excellent impact resistance.

EXAMPLES

The following describes the present invention in further detail by providing examples, although the present invention is not limited to these examples.

<Raw Materials>

- Polyphenylene sulfide (DIC Corporation, MA-520)
- Polyethylene elastomer A (Sumitomo Chemical, Igetabond BF-7L)
- Polyethylene elastomer B (Sumitomo Chemical, Igetabond BF-E)
- Polyethylene elastomer C (Sumitomo Chemical, Igetabond BF-7M)

The following are the proportions of the monomers used as raw materials in making the above polyethylene elastomers. The values are the relative amounts of the monomers (% by mass) to the total mass of the monomers used as raw materials to make the polyethylene elastomer.

[Table 1]

| | Elastomer A | Elastomer B | Elastomer C |
|---|---|---|---|
| Glycidyl dimethacrylate | 3 | 12 | 6 |
| Methyl acrylate | 27 | - | 27 |
| Ethylene | 70 | 88 | 67 |

As stated in the embodiments, the results of a support vector regression analysis performed to produce a resin composite having a good Charpy impact value suggested good manufacturing conditions are those including a higher elastomer ratio and polymer melt temperatures IR1 and IR2 in the range of 300°C to 315°C. Based on this information, resin composites of examples and comparative examples were produced under the following conditions.

<Production of Resin Composites>

[Example 1]

The polyphenylene sulfide resin (80 parts by mass) and polyethylene elastomer A (20 parts by mass) were mixed together, and the resulting mixture was put into a twin-screw extruder.

Fig. 8 is a schematic diagram illustrating the structure of the twin-screw extruder used. The twin-screw extruder was a co-rotating twin-screw extruder with a screw diameter of 15 mm, a tip clearance of 0.25 mm, a ratio between the cylinder length L and the cylinder inner diameter D: L/D = 90, and fifteen barrels (fifteen equally divided barrels, numbered C1 to C15 from the feedstock inlet side toward the ejection side) in a screw configuration in which there were kneading zones at the C4, C7, C10, and C12 positions.

At the preset C2 to C15 barrel temperatures (°C) [Preset temperatures of (cartridge) heaters surrounding the barrels. "Room temperature" for C1 means there was no preset temperature.] and the screw speed presented in Table 2, the polyphenylene sulfide resin and polyethylene elastomer A were melted and kneaded. The strand that came out of the die was cooled and cut, giving pellets of the resin composite of Example 1.

[Table 2]

| | Preset barrel temperatures (°C) | | | | | | | | | | | | | | | | |
|---|---|---|---|---|---|---|---|---|---|---|---|---|---|---|---|---|---|
| | | | | | | IR1 | | | IR2 | | | IR3 | | IR4 | | | |
| | Screw speed (rpm) | C1 | C2 | C3 | C4 | C5 | C6 | C7 | C8 | C9 | C10 | C11 | C12 | C13 | C14 | C15 | Regions below 300°C |
| Example 1 | 1000 | Room temperature | 240 | 280 | 280 | 270 | 270 | 270 | 300 | 300 | 300 | 300 | 300 | 300 | 300 | 300 | 7/15 |
| Example 2 | 1000 | Room temperature | 240 | 240 | 240 | 240 | 240 | 240 | 240 | 300 | 300 | 300 | 300 | 300 | 300 | 300 | 8/15 |
| Example 3 | 1000 | Room temperature | 240 | 300 | 300 | 300 | 300 | 300 | 300 | 300 | 300 | 280 | 240 | 240 | 260 | 260 | 7/15 |
| Example 4 | 1000 | Room temperature | 240 | 300 | 300 | 300 | 300 | 240 | 240 | 240 | 240 | 240 | 240 | 240 | 240 | 240 | 11/15 |
| Comparative Example 1 | 1000 | Room temperature | 240 | 300 | 300 | 300 | 300 | 300 | 300 | 300 | 300 | 300 | 300 | 300 | 300 | 300 | 2/15 |
| Comparative Example 2 | 300 | Room temperature | 240 | 300 | 300 | 300 | 300 | 300 | 300 | 300 | 300 | 300 | 300 | 300 | 300 | 300 | 2/15 |
| Example 5 | 600 | Room temperature | 240 | 280 | 280 | 285 | 285 | 300 | 300 | 300 | 300 | 300 | 300 | 300 | 300 | 300 | 6/15 |
| Example 6 | 600 | Room temperature | 240 | 240 | 240 | 240 | 240 | 240 | 240 | 300 | 300 | 300 | 300 | 300 | 300 | 300 | 8/15 |
| Example 7 | 600 | Room temperature | 240 | 300 | 300 | 300 | 300 | 300 | 300 | 300 | 300 | 280 | 260 | 260 | 280 | 280 | 7/15 |
| Example 8 | 600 | Room temperature | 240 | 300 | 300 | 300 | 300 | 240 | 240 | 240 | 240 | 240 | 240 | 240 | 240 | 240 | 11/15 |
| Comparative Example 3 | 600 | Room temperature | 240 | 300 | 300 | 300 | 300 | 300 | 300 | 300 | 300 | 300 | 300 | 300 | 300 | 300 | 2/15 |
| Comparative Example 4 | 300 | Room temperature | 240 | 300 | 300 | 300 | 300 | 300 | 300 | 300 | 300 | 300 | 300 | 300 | 300 | 300 | 2/15 |
| Example 9 | 1000 | Room temperature | 240 | 280 | 280 | 270 | 270 | 270 | 300 | 300 | 300 | 300 | 300 | 300 | 300 | 300 | 7/15 |

(continued)

| Preset barrel temperatures (°C) | | | | | | | | | | | | | | | | | |
|---|---|---|---|---|---|---|---|---|---|---|---|---|---|---|---|---|---|
| | | | | | | IR1 | | | IR2 | | | IR3 | | IR4 | | | |
| | Screw speed (rpm) | C1 | C2 | C3 | C4 | C5 | C6 | C7 | C8 | C9 | C10 | C11 | C12 | C13 | C14 | C15 | Regions below 300°C |
| Comparative Example 5 | 1000 | Room temperature | 240 | 300 | 300 | 300 | 300 | 300 | 300 | 300 | 300 | 300 | 300 | 300 | 300 | 300 | 2/15 |

[Example 2]

Pellets of the resin composite of Example 2 were obtained via the same procedure as in Example 1, except that the preset barrel temperatures were changed to those specified in Table 2.

[Example 3]

Pellets of the resin composite of Example 3 were obtained via the same procedure as in Example 1, except that the preset barrel temperatures were changed to those specified in Table 2.

[Example 4]

Pellets of the resin composite of Example 4 were obtained via the same procedure as in Example 1, except that the preset barrel temperatures were changed to those specified in Table 2.

[Comparative Example 1]

Pellets of the resin composite of Comparative Example 1 were obtained via the same procedure as in Example 1, except that the preset barrel temperatures were changed to those specified in Table 2.

[Comparative Example 2]

Pellets of the resin composite of Comparative Example 2 were obtained via the same procedure as in Comparative Example 1, except that the screw speed was changed to that specified in Table 2.

[Example 5]

Pellets of the resin composite of Example 5 were obtained via the same procedure as in Example 1, except that the raw materials were changed to the polyphenylene sulfide resin (80 parts by mass) and polyethylene elastomer B (20 parts by mass) and that the screw speed and the preset barrel temperatures were changed as specified in Table 2.

[Example 6]

Pellets of the resin composite of Example 6 were obtained via the same procedure as in Example 5, except that the preset barrel temperatures were changed to those specified in Table 2.

[Example 7]

Pellets of the resin composite of Example 7 were obtained via the same procedure as in Example 5, except that the preset barrel temperatures were changed to those specified in Table 2.

[Example 8]

Pellets of the resin composite of Example 8 were obtained via the same procedure as in Example 5, except that the preset barrel temperatures were changed to those specified in Table 2.

[Comparative Example 3]

Pellets of the resin composite of Comparative Example 3 were obtained via the same procedure as in Example 5, except that the preset barrel temperatures were changed to those specified in Table 2.

[Comparative Example 4]

Pellets of the resin composite of Comparative Example 4 were obtained via the same procedure as in Comparative Example 3, except that the screw speed was changed to that specified in Table 2.

[Example 9]

Pellets of the resin composite of Example 9 were obtained via the same procedure as in Example 1, except that the raw materials were changed to the polyphenylene sulfide resin (80 parts by mass) and polyethylene elastomer C (20 parts by mass).

[Comparative Example 5]

Pellets of the resin composite of Comparative Example 5 were obtained via the same procedure as in Example 9, except that the preset barrel temperatures were changed to those specified in Table 2.

<Measurements>

(Measurement of the Polymer Melt Temperatures inside the Cylinder during the Melt Kneading)

Infrared thermometers were placed at barrel positions C5, C8, C11, and C13 out of the fifteen equally divided barrels. With these thermometers, the temperature (°C) inside the cylinder was measured at a total of four points, from the base to the tip of the screws (Defined as IR1 temperature, IR2 temperature, IR3 temperature, and IR4 temperature.), as the feedstock passed through the respective barrels during the melt kneading using the twin-screw extruder (see Fig. 8).

(Charpy Impact Value)

For each Example or Comparative Example, the resulting resin composite was put into an injection molding machine as a molding material and shaped into a test specimen measuring 80 mm in length × 10.0 mm in width × 4.0 mm in thickness at a preset cylinder temperature of 300°C and a preset mold temperature of 130°C. Then the test specimen was notched ($B_N$: 8 mm) according to ISO 2818 and tested according to ISO 179-1 for the Charpy notched impact value ($kJ/m^2$) at 23°C. Fig. 9 illustrates the shape of a test specimen used in the measurement of the Charpy impact value.

(Diameter of Dispersed Elastomer Particles)

For each Example or Comparative Example, the resulting resin composite pellets were put into an injection molding machine as a molding material and shaped into an ISO 3167 type-A multipurpose test specimen. Then this multipurpose test specimen was cut at the middle in the longitudinal direction, and the cross-section was polished. The cut piece was immersed in xylene and sonicated at a temperature of 50°C, and the dispersed elastomer on the cross-section was removed by extraction with xylene. Then the specimen was dried at 130°C for 2 hours, and the cross-section was observed and imaged by SEM. The image had void phases corresponding to the areas in which the elastomer had been removed, displayed in round shapes in low-brightness black. All such black round objects seen in the image's field of view (n = 300 or more) were measured on image analysis software for their equivalent circular diameter (calculated diameter of a perfect circle equivalent to the area of the round object), and the average, given by dividing the total by the number of round objects, was reported as the average diameter (μm) of dispersed particles of the elastomer.

(Melt Viscosity)

For each Example or Comparative Example, the resulting resin composite pellets were put into a flow tester with a cylinder temperature of 300°C, an orifice length of 10 mm, and an orifice diameter of 1 mm. After 6 minutes of preheating, the melt viscosity was measured under a test load of 50 kg.

The results of these measurements are presented in Tables 3 to 5.

[Table 3]

| | | Example 1 | Example 2 | Example 3 | Example 4 | Comparative Example 1 | Comparative Example 2 |
|---|---|---|---|---|---|---|---|
| Manufacturing conditions | Ejection (kg/h) | 3 | 3 | 3 | 3 | 3 | 3 |
| | Screw speed (rpm) | 1000 | 1000 | 1000 | 1000 | 1000 | 300 |
| | Shear rate ($s^{-1}$) | 3142 | 3142 | 3142 | 3142 | 3142 | 942 |
| Measurement results | IR1 temperature (°C) | 310 | 282 | 326 | 323 | 328 | 315 |
| | IR2 temperature (°C) | 303 | 280 | 306 | 277 | 320 | 316 |
| | IR3 temperature (°C) | 313 | 312 | 310 | 276 | 316 | 312 |
| | IR4 temperature (°C) | 325 | 326 | 313 | 282 | 332 | 313 |
| | Charpy impact value ($kJ/m^2$) | 65 | 62 | 61 | 62 | 58 | 41 |
| | Average diameter of dispersed elastomer particles (μm) | 0.16 | 0.12 | 0.17 | 0.12 | 0.18 | 0.25 |
| | Melt viscosity (Pa·s) | 348 | 463 | 392 | 517 | 310 | 226 |

[Table 4]

| | | Example 5 | Example 6 | Example 7 | Example 8 | Comparative Example 3 | Comparative Example 4 |
|---|---|---|---|---|---|---|---|
| Manufacturing conditions | Ejection (kg/h) | 3 | 3 | 3 | 3 | 3 | 3 |
| | Screw speed (rpm) | 600 | 600 | 600 | 600 | 600 | 300 |
| | Shear rate ($s^{-1}$) | 1885 | 1885 | 1885 | 1885 | 1885 | 942 |

(continued)

| | | Example 5 | Example 6 | Example 7 | Example 8 | Comparative Example 3 | Comparative Example 4 |
|---|---|---|---|---|---|---|---|
| Measurement results | IR1 temperature (°C) | 309 | 278 | 319 | 324 | 322 | 316 |
| | IR2 temperature (°C) | 307 | 276 | 304 | 280 | 313 | 301 |
| | IR3 temperature (°C) | 316 | 316 | 307 | 278 | 330 | 316 |
| | IR4 temperature (°C) | 337 | 324 | 314 | 286 | 345 | 321 |
| | Charpy impact value (kJ/m$^2$) | 62 | 62 | 58 | 62 | 56 | 56 |
| | Average diameter of dispersed elastomer particles (μm) | 0.12 | 0.11 | 0.12 | 0.09 | 0.12 | 0.15 |
| | Melt viscosity (Pa·s) | 7540 | 9880 | 12450 | 21200 | 6700 | 3600 |

[Table 5]

| | | Example 9 | Comparative Example 5 |
|---|---|---|---|
| Manufacturing conditions | Ejection (kg/h) | 3 | 3 |
| | Screw speed (rpm) | 1000 | 1000 |
| | Shear rate (s$^{-1}$) | 3142 | 3142 |
| Measurement results | IR1 temperature (°C) | 309 | 329 |
| | IR2 temperature (°C) | 304 | 338 |
| | IR3 temperature (°C) | 324 | 330 |
| | IR4 temperature (°C) | 348 | 363 |
| | Charpy impact value (kJ/m$^2$) | 64 | 52 |
| | Average diameter of dispersed elastomer particles (μm) | 0.16 | 0.18 |
| | Melt viscosity (Pa·s) | 1161 | 990 |

For Comparative Example 2, the kneading was performed at a low screw speed of 300 rpm. The average diameter of particles of the elastomer dispersed in the resin composite, too, was relatively large, resulting in a poor Charpy impact value.

In Comparative Example 1, the screw speed was 1000 rpm. The average diameter of dispersed particles of

the elastomer was small, and an improvement was observed in the state of dispersion of the elastomer in the resin composite.

In the Examples, a data set was created including all of control, measured, and characteristics variables as described above. Importance was calculated using the random forest algorithm, and a regression analysis was carried out with items ranked high in terms of importance using the support vector machine algorithm. Based on the suggested results, the resin composites of the Examples were produced employing predetermined manufacturing conditions in terms of the elastomer content, the screw speed of the twin-screw extruder, and the polymer melt temperatures inside the extruder's cylinder.

As a result, the articles shaped from the resin composites actually had an extremely high Charpy impact value, validating machine learning-assisted development of highly functional materials.

In Examples 1 and 2, the preset barrel temperatures at C2 to C7 or C2 to C8, corresponding to the positions from IR1 to IR2, were lower. By virtue of this, the articles shaped from the resin composites were superior in Charpy impact value compared with that in Comparative Example 1, in which the preset barrel temperatures at all positions (C2 to C15) were 300°C.

In Example 3, furthermore, the preset barrel temperatures at C11 to C15, corresponding to the positions from IR3 to 4, were lower, and in Example 4 those of the barrels corresponding to the positions from IR2 to IR4 (C7 to C15) were lower. As in Examples 1 and 2, the articles shaped from the resin composites were superior in Charpy impact value compared with that in Comparative Example 1.

Interestingly, when Examples 1 and 2 were compared with Examples 3 and 4, the Charpy impact value was even higher in Examples 1 and 2, in which temperatures near the IR1 and IR2 positions were changed to lower levels. This was consistent with the analytical results obtained by the importance calculation using the random forest algorithm, i.e., high importance of IR1 and IR2.

In Examples 5 to 8 and Comparative Examples 3 and 4, in which resin composites made with different elastomers were tested in the same way, a similar trend was observed to that in Examples 1 to 4 and Comparative Examples 1 and 2.

Example 9 and Comparative Example 5, furthermore, were examples in which resin composites made with elastomer C, not used in creating the data set for the machine learning, were tested in the same way. As in the other results, the results of the machine learning were found to be applicable.

When referring to the melt viscosity values, the melt viscosity tended to improve with smaller average diameters of dispersed particles and increasing dispersibility of the elastomer. Reduced thermal degradation of the elastomer resulting from lower preset barrel temperatures, the inventors believe, also led to the improvement in melt viscosity.

The tests demonstrated that modified conditions obtained via machine learning are greatly effective in manufacturing a resin composite with a high percentage of a thermoplastic elastomer, in which improving dispersibility has been a challenge. Melting and kneading the ingredients under high shear conditions improved the dispersibility of the thermoplastic elastomer by making the average diameter of dispersed particles of the elastomer smaller. Lowering measured polymer melt temperatures during the melt kneading, furthermore, improved the efficiency of the dispersion process, presumably by reducing the flowability of the polyarylene sulfide resin, helping further improve the dispersibility of the thermoplastic elastomer. The low polymer melt temperatures also reduced thermal decomposition of the polyarylene sulfide resin and the thermoplastic elastomer. As a result of these, the inventors believe, the resulting resin composites and articles shaped therefrom had an extremely high Charpy impact value.

The structural elements, configurations, and arrangements, their combinations, etc., in the embodiments are provided for illustrative purposes. Additions, omissions, substitutions, and other changes can be made to the elements, configurations, and arrangements without departing from the gist of the present invention. The present invention, furthermore, is not limited by the embodiments but is limited only by the scope of what is claimed (the claims).

Reference Signs List

10 ... Twin-screw extruder, 11 ... driver, 12 ... feeder, 13 ... cylinder, 14 ... screws, 19 ... die, 20 ... machine learning algorithm, 30 ... storage device, DS ... data set, CD ... manufacturing conditions data, MD ... measured characteristics data, HC ... highly critical items, IR ... infrared temperature sensors, IR1 ... first infrared temperature sensor, IR2 ... second infrared temperature sensor, IR3 ... third infrared temperature sensor, IR4 ... fourth infrared temperature sensor

## Claims

1. A method for optimizing manufacturing conditions for a polyarylene sulfide resin composite, the method comprising: executing a machine learning algorithm using a data set including manufacturing conditions data and measured characteristics data, the manufacturing conditions data including manufacturing conditions items of at least ingredients for the polyarylene sulfide resin composite, mixing conditions, and polymer melt temperature during melt kneading whereas the measured characteristics data including a characteristic value item of at least impact resistance of the polyarylene sulfide resin composite when produced under manufacturing conditions specified by the manufacturing conditions data, to find out which of the plurality of items included in the manufacturing conditions data and the measured characteristics data is highly important for changes in a characteristic value for a target item for improved characteristics of the polyarylene sulfide resin composite selected as an objective variable.

**2.** The method according to Claim 1 for optimizing manufacturing conditions for a polyarylene sulfide resin composite, wherein:

the machine learning algorithm is a random forest-based algorithm; and
the algorithm determines the item highly important for changes in the characteristic value for the target item for improved characteristics by calculating importance of each of the plurality of items included in the manufacturing conditions data and the measured characteristics data.

**3.** The method according to Claim 2 for optimizing manufacturing conditions for a polyarylene sulfide resin composite, wherein:
the manufacturing conditions items included in the manufacturing conditions data include at least one in a first class, which is to be controlled by a production system with which the polyarylene sulfide resin composite is manufactured, and at least one in a second class, which is not to be controlled by the production system.

**4.** The method according to Claim 3 for optimizing manufacturing conditions for a polyarylene sulfide resin composite, wherein:
the manufacturing conditions item in the second class includes internal temperatures of a kneader of the production system, at which a polyarylene sulfide resin is kneaded, at a plurality of points.

**5.** The method according to Claim 4 for optimizing manufacturing conditions for a polyarylene sulfide resin composite, wherein:
of the internal temperatures of the kneader at a plurality of points, which are manufacturing conditions items in the second class, an upstream one, which is on a side where raw materials for the polyarylene sulfide resin composite are introduced into the kneader, has a higher level of the importance than a downstream one, which is on a side where the kneaded polyarylene sulfide resin composite is extruded.

**6.** The method according to any one of Claims 2 to 5 for optimizing manufacturing conditions for a polyarylene sulfide resin composite, wherein:
the machine learning algorithm is executed with the item with high calculated importance as a new objective variable to find out which item is highly important for changes in a characteristic value for the new objective variable.

**7.** The method according to any one of Claims 2 to 6 for optimizing manufacturing conditions for a polyarylene sulfide resin composite, wherein:
a regression operation using the data set is performed with the item with a high calculated level of the importance as an analytical axis to estimate correspondence between changes in a characteristic value for the item with a high level of the importance and changes in the characteristic value for the objective variable.

**8.** A method for manufacturing a polyarylene sulfide resin composite containing a polyarylene sulfide resin (A) and a thermoplastic elastomer (B),
a percentage of the thermoplastic elastomer (B) being between 5% and 30% by mass of a total mass of the polyarylene sulfide resin composite, the method comprising:
a step of melting and kneading a raw-material polyarylene sulfide resin (A) and a raw-material thermoplastic elastomer (B) with an extruder, wherein:

a shear rate the extruder generates by rotating a screw thereof with respect to an inner wall of a cylinder thereof is between 1000 and 6500 $s^{-1}$; and
a preset temperature of the cylinder is below 300°C over a length of the cylinder equal to or longer than 3/15 of a whole length of the cylinder.

**9.** The method according to Claim 8 for manufacturing a resin composite, wherein the thermoplastic elastomer (B) is a polyolefin thermoplastic elastomer.

**10.** The method according to Claim 9 for manufacturing a resin composite, wherein the thermoplastic elastomer (B) is a glycidyl-modified polyolefin thermoplastic elastomer.

**11.** The method according to Claim 9 or 10 for manufacturing a resin composite, wherein the thermoplastic elastomer (B) contains:

0.1% to 30% by mass of a glycidyl (meth)acrylate-derived unit; and
0.1% to 50% by mass of a methyl acrylate-derived unit,
based on a total mass (100% by mass) of units forming the thermoplastic elastomer (B).

**12.** The method according to any one of Claims 8 to 11 for manufacturing a resin composite, wherein the resin composite has a dispersion structure in which an average diameter of dispersed particles of the thermoplastic elastomer (B) is 0.20 μm or less.

**13.** The method according to any one of Claims 8 to 12 for manufacturing a resin composite, wherein a Charpy notched impact value at 23°C of an article shaped from the resin composite measured as per ISO 179-1 is 40 $kJ/m^2$ or more.

FIG. 1

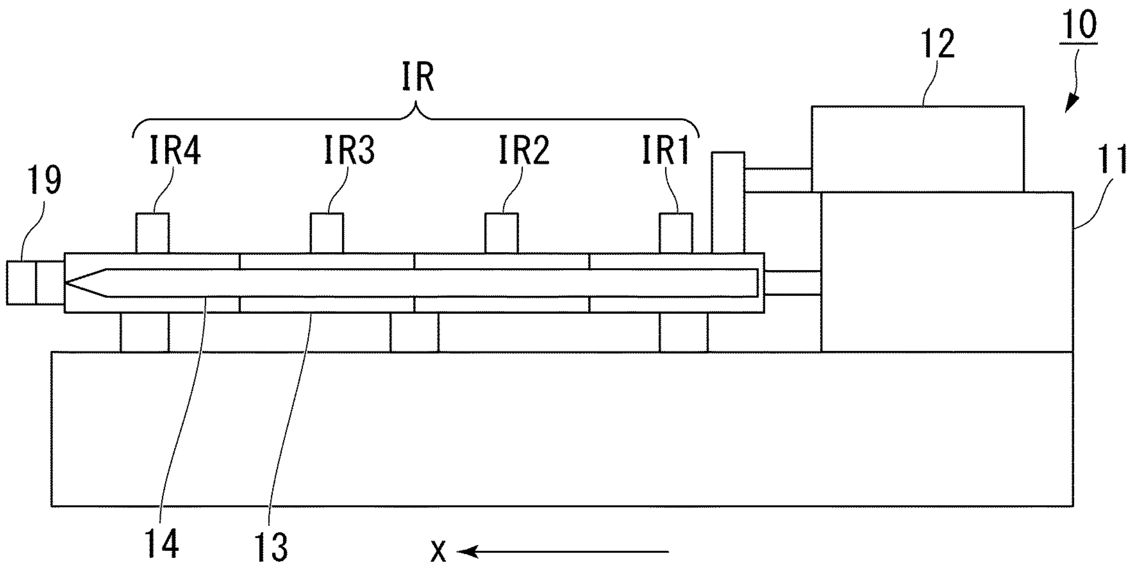
IR
IR4
IR3
IR2
IR1
19
12
10
11
14
13
X

FIG. 2

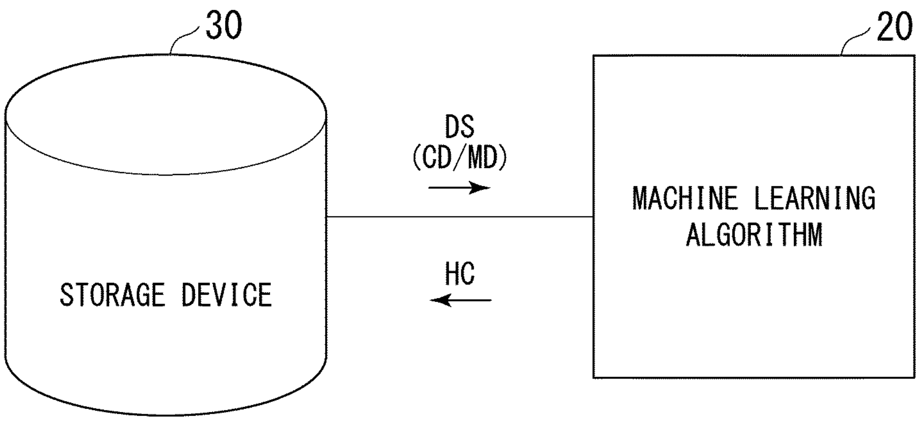
30
20
STORAGE DEVICE
DS
(CD/MD)
HC
MACHINE LEARNING
ALGORITHM

FIG. 3

CD: CD1, CD2 — MD

| FIRST MODIFICATION OF THE ELASTOMER | SECOND MODIFICATION OF THE ELASTOMER | TOTAL MODIFICATION | ELASTOMER RATIO (wt%) | SCREW SPEED | ELECTRICAL CURRENT (A) | POLYMER MELT PRESSURE (MPa) | IR1 TEMPERATURE (°C) | IR2 TEMPERATURE (°C) | IR3 TEMPERATURE (°C) | IR4 TEMPERATURE (°C) | MELT VISCOSITY (Pa・s) | AVERAGE DIAMETER OF DISPERSED ELASTOMER PARTICLES (μm) | CHARPY IMPACT VALUE (kJ/m²) | ... |
|---|---|---|---|---|---|---|---|---|---|---|---|---|---|---|
| x1 | x2 | x3 | x4 | x5 | y1 | y2 | y3 | y4 | y5 | y6 | y7 | y8 | y9 | ... |
| 3 | 27 | 30 | 2 | 150 | 75 | 1.5 | 306 | 310 | 307 | 308 | 156 | 0.178 | 3.5 | ... |
| 3 | 27 | 30 | 2 | 300 | 88 | 1.4 | 316 | 319 | 316 | 316 | 136 | 0.118 | 3.6 | ... |
| ... | ... | ... | ... | ... | ... | ... | ... | ... | ... | ... | ... | ... | ... | ... |

DS1 (DS)
DS2 (DS)

FIG. 4

| FIRST MODIFICATION OF THE ELASTOMER | SECOND MODIFICATION OF THE ELASTOMER | TOTAL MODIFICATION | ELASTOMER RATIO (wt%) | SCREW SPEED | ELECTRICAL CURRENT (A) | POLYMER MELT PRESSURE (MPa) | IR1 TEMPERATURE (°C) | IR2 TEMPERATURE (°C) | IR3 TEMPERATURE (°C) | IR4 TEMPERATURE (°C) | MELT VISCOSITY (Pa·s) | AVERAGE DIAMETER OF DISPERSED ELASTOMER PARTICLES (μm) | CHARPY IMPACT VALUE ($kJ/m^2$) | Score |
|---|---|---|---|---|---|---|---|---|---|---|---|---|---|---|
| x1 | x2 | x3 | x4 | x5 | y1 | y2 | y3 | y4 | y5 | y6 | y7 | y8 | y9 | |
| 1.4 | 1.2 | 1.1 | 57.6 | 3.2 | 0.8 | 5.3 | 11.3 | 10.2 | 1.1 | 1.3 | 4.7 | 0.9 | target | 98.8 |

CD: CD1 (x1–x5), CD2 (y1–y6)

MD (y7–y9)

HC (x4), HC (y3), HC (y4)

FIG. 5

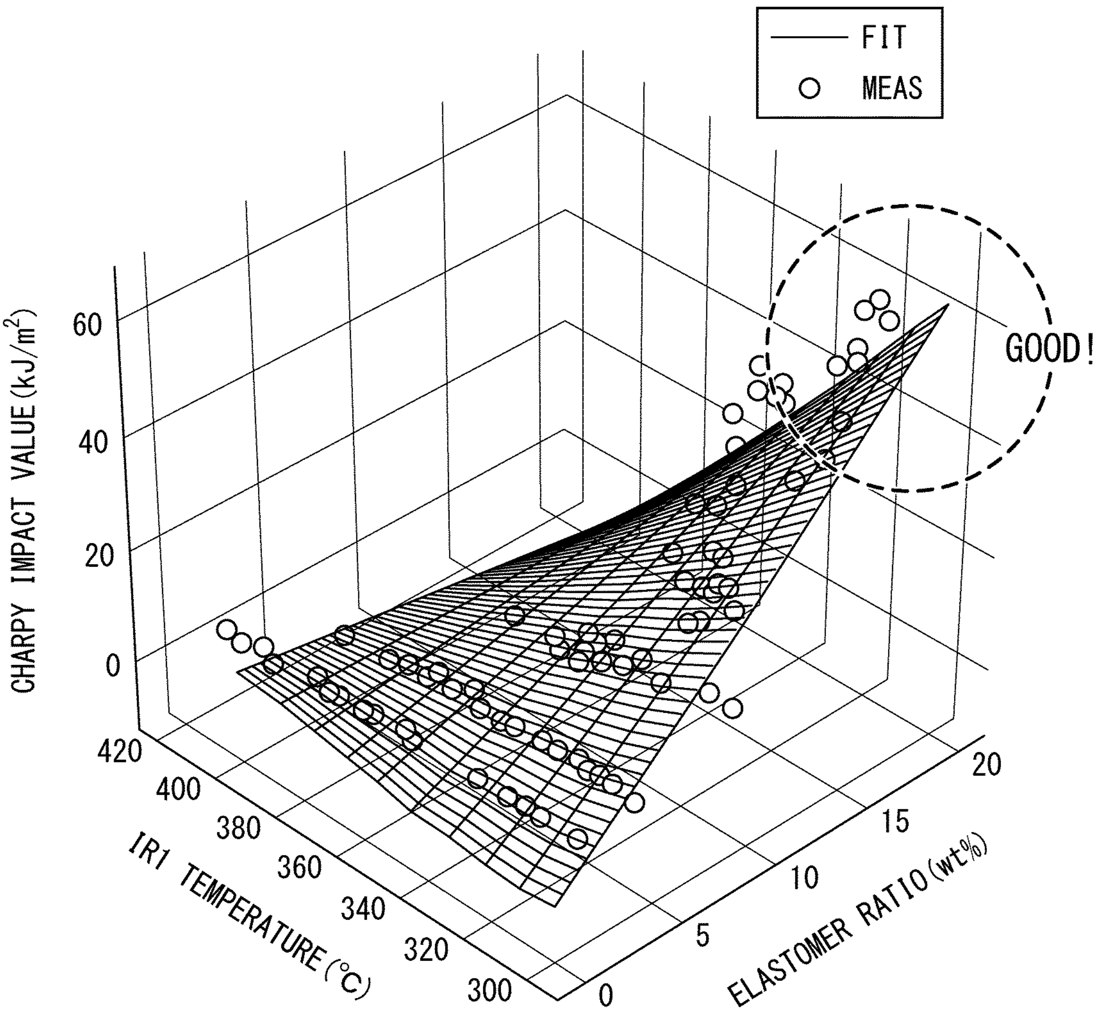
FIT
MEAS
GOOD!
CHARPY IMPACT VALUE (kJ/m2)
60
40
20
0
420
400
380
360
340
320
300
IR1 TEMPERATURE (°C)
0
5
10
15
20
ELASTOMER RATIO (wt%)

FIG. 6

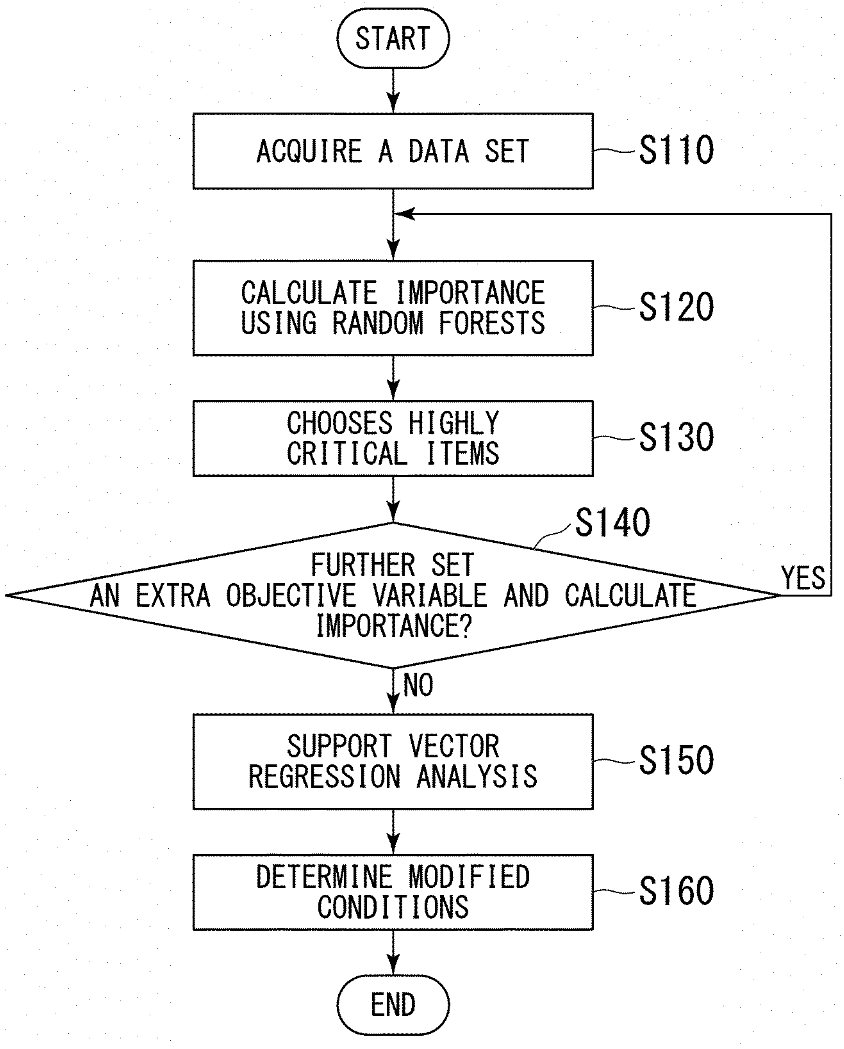
START
ACQUIRE A DATA SET
S110
CALCULATE IMPORTANCE USING RANDOM FORESTS
S120
CHOOSES HIGHLY CRITICAL ITEMS
S130
S140
FURTHER SET AN EXTRA OBJECTIVE VARIABLE AND CALCULATE IMPORTANCE?
YES
NO
SUPPORT VECTOR REGRESSION ANALYSIS
S150
DETERMINE MODIFIED CONDITIONS
S160
END

FIG. 7

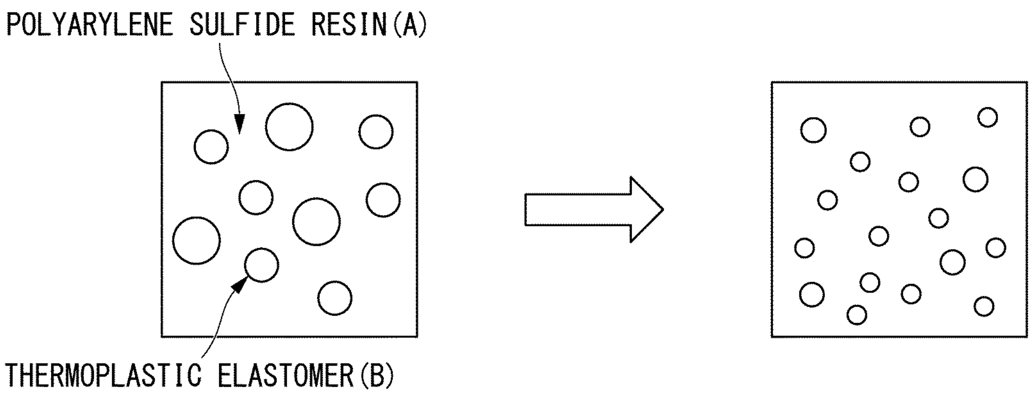

FIG. 8

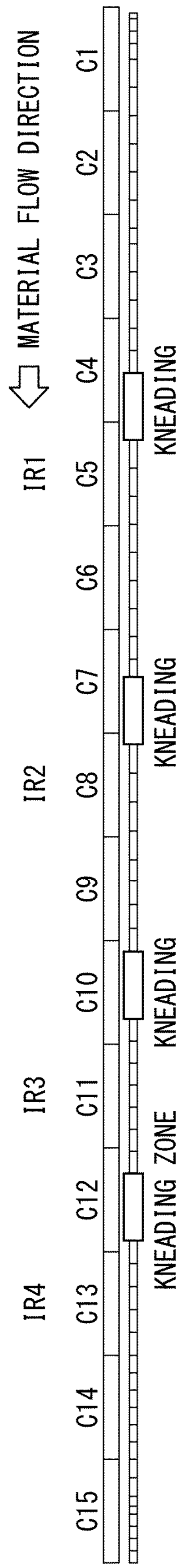
MATERIAL FLOW DIRECTION
C1
C2
C3
C4
C5
C6
C7
C8
C9
C10
C11
C12
C13
C14
C15
IR1
IR2
IR3
IR4
KNEADING
KNEADING
KNEADING
KNEADING ZONE

FIG. 9

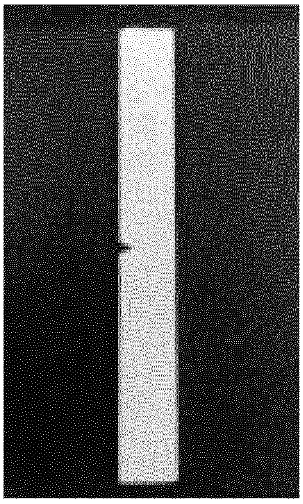

(L : 80mm × b : 10mm × h : 4mm, $b_N$ : 8mm)

## INTERNATIONAL SEARCH REPORT

International application No.
PCT/JP2021/005897

A. CLASSIFICATION OF SUBJECT MATTER
G06F 30/27(2020.01)i; C08L 23/00(2006.01)i; C08L 81/02(2006.01)i
FI: G06F30/27; C08L23/00; C08L81/02

According to International Patent Classification (IPC) or to both national classification and IPC

B. FIELDS SEARCHED

Minimum documentation searched (classification system followed by classification symbols)
G06F30/00-30/28; C08L23/00; C08L81/02

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2014-041483 A (KOBE STEEL, LTD.) 06 March 2014 (2014-03-06) paragraphs [0037]-[0040] | 1-13 |
| A | JP 2006-321340 A (BRIDGESTONE CORPORATION) 30 November 2006 (2006-11-30) paragraphs [0136]-[0198] | 1-13 |
| A | WO 2009/088092 A1 (RIKKYO GAKUIN) 16 July 2009 (2009-07-16) page 22, line 5 to page 25, line 10 | 1-13 |
| A | JP 2020-506257 A (TICONA LLC) 27 February 2020 (2020-02-27) paragraphs [0030]-[0034] | 1-13 |

☐ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 06 May 2021 (06.05.2021) | 18 May 2021 (18.05.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2021/005897

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:
See extra sheet

1. ☐ As all required additional search fees were timely paid by the applicant, this international search report covers all searchable claims.
2. ☒ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (January 2015)

**INTERNATIONAL SEARCH REPORT**
Information on patent family members

International application No.
PCT/JP2021/005897

| Patent Documents referred in the Report | Publication Date | Patent Family | Publication Date |
|---|---|---|---|
| JP 2014-041483 A | 06 Mar. 2014 | (Family: none) | |
| JP 2006-321340 A | 30 Nov. 2006 | (Family: none) | |
| WO 2009/088092 A1 | 16 Jul. 2009 | (Family: none) | |
| JP 2020-506257 A | 27 Feb. 2020 | US 2018/0212208 A1 paragraphs [0035]-[0043]<br>WO 2018/140309 A1<br>CN 110225935 A | |

Form PCT/ISA/210 (patent family annex) (January 2015)

**INTERNATIONAL SEARCH REPORT**

International application No. PCT/JP2021/005897

<Continuation of Box No. III>

The claims are classified into the following two inventions.

(Invention 1) Claims 1-7

Claims 1-7 have the special technical feature of a "method for determining production conditions of a polyarylene sulfide resin composition, wherein by performing a machine learning algorithm using a data set, which includes: production condition data including, as production condition items, at least blending components for a polyarylene sulfide resin composition, mixing conditions, and the temperature of a kneaded product during melt-kneading; and physical property measurement data including, as a characteristic value item, at least the impact resistance of a polyarylene sulfide resin composition produced under the production conditions indicated by the production condition data, when the characteristic value of a target item for improving the characteristics of the polyarylene sulfide resin composition is used as an objective variable, an item having a high importance for a change in the characteristic value of the target item for improving the characteristics is determined among the plurality of items included in the production condition data and the physical property measurement data", and are thus classified as invention 1.

(Invention 2) Claims 8-13

Claims 8-13 cannot be said to share an identical or corresponding special technical feature with claim 1 classified as invention 1.

Moreover, claims 8-13 are not dependent on claim 1. Furthermore, claims 8-13 are not substantially identical or equivalent to any of the claims classified as invention 1.

Therefore, claims 8-13 cannot be classified as invention 1.

In addition, claims 8-13 have the special technical feature of a "method for producing a polyarylene sulfide resin composition containing a polyarylene sulfide resin (A) and a thermoplastic elastomer (B), wherein the blending proportion of the thermoplastic elastomer (B) is 5-30 mass% with respect to the total mass of the polyarylene sulfide resin composition, a step for melt-kneading the polyarylene sulfide resin (A), which is a raw material, and the thermoplastic elastomer (B), which is a raw material, using an extruder is included, the shear rate generated through the screw rotation with respect to a cylinder inner wall of the extruder is 1,000-6,500 s-1, and the set temperature of the cylinder is lower than 300°C in a region having a length of at least 3/15 with respect to the total length of the cylinder", and are thus classified as invention 2.

Form PCT/ISA/210 (extra sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 62982756 B
- JP 2020159132 A
- JP 2017149002 A
- JP 2008163112 A